# EUROPEAN PATENT SPECIFICATION

(11) **EP 2 989 662 B1**
(45) Date of publication and mention of the grant of the patent: **23.11.2016**
(21) Application number: 14731004.9
(22) Date of filing: 15.04.2014
(51) Int. Cl.: H01L 31/02, H01L 31/05, H01L 31/0224, H01L 31/18, H01L 31/049

(54) **BACK-CONTACT BACK-SHEET FOR PHOTOVOLTAIC MODULES WITH PASS-THROUGH ELECTRIC CONTACTS**
RÜCKSEITENKONTAKTFOLIE FÜR PHOTOVOLTAIKMODULE MIT DURCH DAS GEHÄUSE GEFÜHRTEN ELEKTRISCHEN KONTAKTEN
PANNEAU ARRIÈRE À CONTACT ARRIÈRE POUR MODULES PHOTOVOLTAÏQUES AVEC CONTACTS ÉLECTRIQUES TRAVERSANTS

(30) Priority: 24.04.2013 IT VI20130117
(43) Date of publication of application: 02.03.2016
(73) Proprietor: Ebfoil S.r.l., 40124 Bologna (IT)
(72) Inventor: BACCINI, Elisa, I-31030 Carbonera (TV) (IT); MARRAS, Luigi, I-34076 Medea (GO) (IT); BUCCI, Bruno, I-40055 Castenaso (BO) (IT)
(74) Representative: Grünecker Patent- und Rechtsanwälte PartG mbB
(86) International application number: PCT/IB2014/060740
(87) International publication number: WO 2014/174407

(56) References cited:
- HANITA COATINGS: "DuraShield Back-Contact Sheets", INTERNET CITATION, 13 June 2012 (2012-06-13), pages 1-2, XP002712000, Retrieved from the Internet: URL:http://www.hanitaenergy.com/sites/hani ta/UserContent/files/PV%20PDF/PV_BACKCONTA CT_page_v5.pdf [retrieved on 2013-08-28]

## Description

### TECHNICAL FIELD OF THE INVENTION:

The present invention relates to the field of photovoltaic modules including back-contact cells. In particular, the present invention relates to novel back-contact back-sheets for a photovoltaic module and manufacturing methods thereof. Yet more in detail, the present invention relates to a back-contact back-sheet and a manufacturing method thereof which allow the electric signal to be transferred outside the photovoltaic module in a simple and effective manner. Yet more in particular, the present invention relates to a back-contact back-sheet and a manufacturing method thereof which allow the terminals for electrical connection towards the outside of the photovoltaic module to contact the connecting circuit to the photovoltaic cells from the surface exposed towards the inside of the photovoltaic module.

### STATE OF THE ART

Solar cells are used for converting solar light into electrical energy by means of the photovoltaic effect. Solar cells are, thus, one of the most promising alternative energy sources for replacing fossil fuels. Solar cells are formed of semiconductor materials and are assembled so as to form so called photovoltaic modules, which are in turn grouped in order to form photovoltaic plants to be typically installed on building roofs or the like.

In order to form a photovoltaic module, groups of solar cells are typically encapsulated by means of an encapsulating material such as a copolymer of ethylene and vinyl acetate, commonly known as EVA. The encapsulating material enclosing the solar cells is then inserted between a surface layer and a base layer or back-sheet, so as to complete the photovoltaic module.

The surface layer, or main surface of the module, typically made of glass, covers the surface of the module exposed to the sun and allows the solar light to reach the cells. On the other hand, the back-sheet carries out a multiplicity of tasks. It guarantees protection of the encapsulating material and of the solar cells from environmental agents, while simultaneously preventing the electrical connections from oxidizing. In particular, the back-sheet prevents moisture, oxygen and other factors depending on the atmospheric conditions from damaging the encapsulating material, the cells and the electrical connections. The back-sheet also provides for electrical insulation for the cells and the corresponding electrical circuits. Furthermore, the back-sheet has to have a high degree of opacity due to esthetic reasons and high reflectivity in the part oriented toward the sun for functional reasons.

The electrical connection in photovoltaic modules comprising traditional solar cells occurs on both the front and the rear side of the cell. In particular the front electrode, i.e. the electrode exposed to the sun light, is electrically contacted by means of a technique called "H-patterning", which causes shading problems of the surface exposed to the sun light. These shading problems are due to the presence of metallic traces screening the light incident upon the front surface of the cell. Traditional electric contacts thus cause the efficiency of solar cells and modules to decrease.

Back-contact cells are a new, more efficient and cost-effective generation of photovoltaic cells, wherein the contacts with both electrodes of the cell are transferred to the rear side of the cell, i.e. onto the side not exposed to the light radiation.

Metallization Wrap Through (MWP) cells turn out to be a particularly efficient and easy-to-implement type of back-contact cell. In MWT cells, the contact to the front electrode is transferred to the rear side of the cell by means of a through-hole extending through the entire thickness of the semiconductor substrate.

Back-contact cells pose new technological problems concerning the design and the structure of the modules adapted to accommodate them. For example, the back-sheet has to be designed so as to support a connecting circuit which is brought into electrical contact with the ohmic contacts formed on the rear side of the cell. These ohmic contacts are connected to both electrodes (base and emitter) of the cell. One of the solutions to this problem is the so called back-contact back-sheet, which is an evolution of the traditional back-sheet, wherein the connecting circuit is implemented directly on the surface of the back-sheet facing the cell.

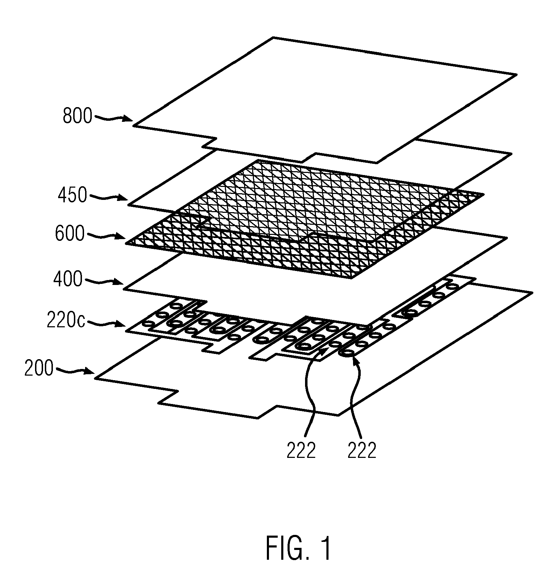

In Figure 1 the structure of a photovoltaic module comprising back-contact solar cells is shown.

Back-contact cell 600 is arranged between an upper encapsulating material layer 450 and a lower encapsulating material layer 400. Cell 600 and encapsulating material layers 400 and 450 are then enclosed between a surface layer 800 typically made of glass or of a transparent and antireflective material and the back-sheet 200, which may be a back-contact back-sheet.

In Figure 1 there are visible the paths of electrically conductive material making up the connecting circuit 220c to the electrodes of the solar cell. Adjacent paths are separated by channels in which the conductive material is absent. If back-sheet 200 is a back-contact back-sheet, the connecting circuit is formed directly on the surface of the lower-lying insulating substrate and is firmly fixed thereto.

The connecting circuit 220c is used so as to ensure an electrical contact with both electrodes (i.e. with the base and the emitter) of solar cell 600. In particular, the paths of electrically conductive material are provided with pads 222 marking the points of the connecting circuit which are to be electrically connected with a contact area on one of the electrodes formed on the rear surface of cell 600.

The procedure of assembling a photovoltaic module such as that shown in Figure 1 is typically performed in the manner described in the following.

The lower encapsulating material layer 400 to be arranged between the cell 600 and the back-contact or back-contact back-sheet 200 is pierced so that, after the module has been completed, the holes formed in the lower encapsulating layer 400 correspond to areas where pads 222 for contact with the electrodes are arranged.

The pierced encapsulating material layer 400 is then laid on top of the inner face of back-sheet or back-contact back-sheet 200, i.e. onto the face of the back-sheet or back-contact back-sheet 200 exposed towards the inside of the photovoltaic module. When applying lower encapsulating material layer 400, the encapsulating material foil is aligned to back-sheet or back-contact back-sheet 200 so that the holes in lower encapsulating material layer 400 correspond or are aligned to pads 222. In this manner, pads 222 are left exposed towards the inside of the photovoltaic module.

A lump or drop of an electrically conductive material, such as for example a conductive paste known as "Electro Conductive Adhesive" (ECA), is then deposited onto pads 222 of the conductive paths of connecting circuit 220c.

Subsequently, the cells 600 to be embedded in the module are placed onto the lower encapsulating material layer 400 so that each contact element on the electrodes formed on the rear surface of the cells comes into contact with a lump of conductive paste applied to one of the pads 222 and exposed to the contact with cells 600 through one of the holes of the lower encapsulating material layer 400. The upper encapsulating material layer 450 is then placed onto the upper surface of the cell 600, opposite the rear surface in contact with the conductive paste applied to pads 222. Finally, a layer 800 of a transparent and antireflective material is laid onto the upper encapsulating material layer 450.

After the structure has been prepared as described above, this can be turned upside-down and subsequently laminated in vacuum at a temperature between 145 °C and 165 °C for a time interval variable between 8 and 18 minutes.

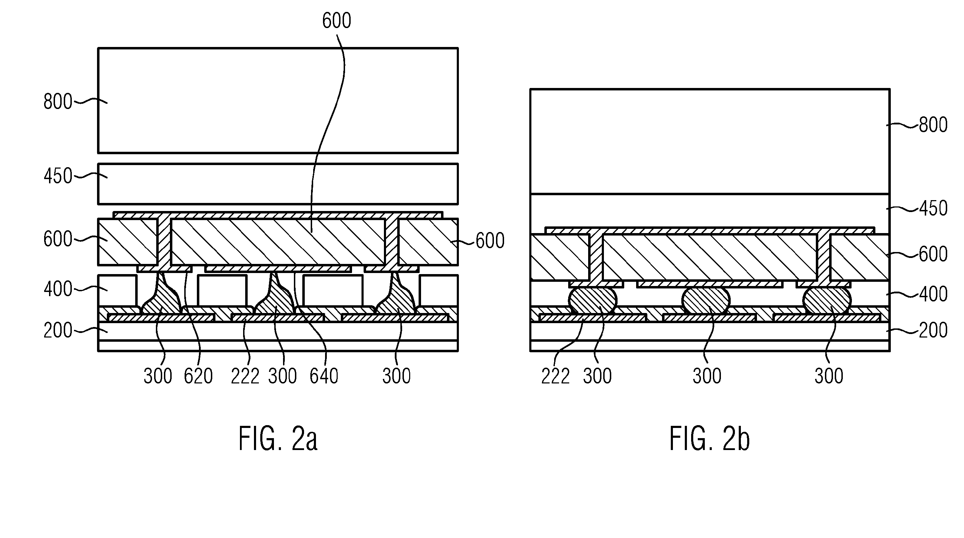

Figure 2a shows the structure of the module before the lamination process. The components of the module, stacked as previously described, are singularly distinguishable. In particular, Figure 2a shows a stack comprising, starting from the bottom and moving towards the top of the figure, the back-sheet or back-contact back-sheet 200 with conductive pads 222 upon which conductive paste 300 has been applied, the lower encapsulating material layer 400, cells 600, the upper encapsulating material layer 450 and surface layer 800.

The electrical connection to the electrodes (base and emitter) of cell 600 is guaranteed by contact points 620 and 640 formed on the rear side of cell 600, i.e. on the side facing connecting circuit 220c and back-sheet 200. Contact points 620 and 640 may be connected to the positive and negative electrode of the photovoltaic cell, respectively.

Figure 2b schematically shows the structure of the module after the lamination process has taken place. During the first lamination stage, the structure is arranged into a vacuum chamber from which the air is evacuated by means of pumps. A pressure is then applied to the structure so as to compact the layers of which the photovoltaic module structure is comprised, while simultaneously maintaining a vacuum in the area in which the module is situated. The whole cycle has preferably a total duration less then 18 minutes. The cycle preferably occurs at a temperature between 140 °C and 165 °C.

The lamination results in hardening of the conductive paste 300 induced by polymerization, thereby causing cells 600 to attach to back-sheet 200. Furthermore, a task of the lamination process is also causing melting and subsequent polymerization of the upper and lower encapsulating material layers 450 and 400.

After the photovoltaic module has been assembled by following the process described above, interconnection terminals, or busbars, are applied between the assembled module and other modules included in the photovoltaic plant.

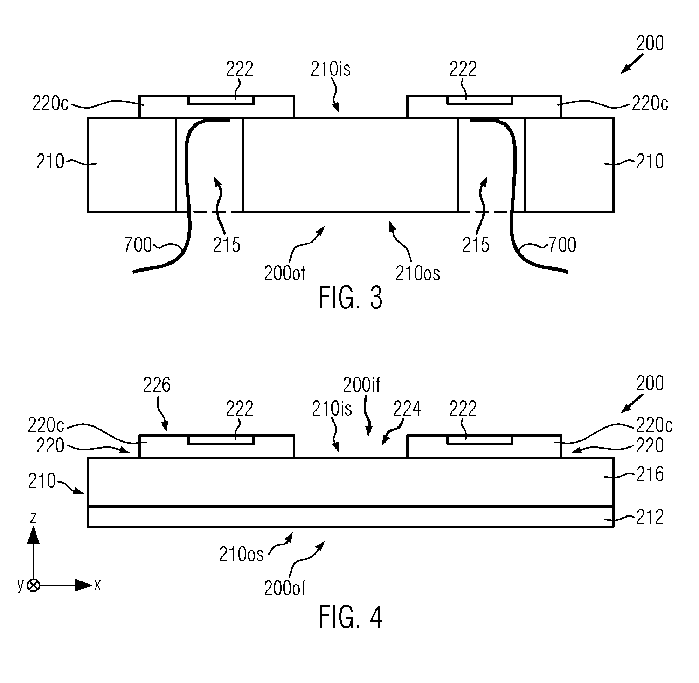

Fig. 3 shows a back-contact back-sheet 200 after busbars 700 for connection to a junction-box have been applied according to the prior art.

Figure 3 shows a back-contact back-sheet 200 after busbars 700 for connection to a junction box have been applied according to the prior art. Back-contact back sheet 200 is comprised of an insulating substrate 210 upon which connecting circuit 220c is fixed. Holes or " windows" 215 are formed in insulating substrate 210 so as to bring into communication the upper surface 210os of insulating substrate 210 exposed towards the air-side of the photovoltaic module with the inner surface 210is of insulating substrate 210 facing the inside of the photovoltaic module. Holes 215 extend through the whole thickness of insulating substrate 210 of the back-contact back-sheet 200 so as to reach the lower surface of connecting circuit 220c facing insulating substrate 210. Holes or windows 215 thus leave the lower surface of connecting circuit 220c exposed towards the air-side of the photovoltaic module and must be adequately positioned in order to enable access to the connecting circuit 220c at predetermined positions. The number of windows 215 thus formed are usually four: one is used for the input, one for the output, and the remaining two are used in order to permit connection to one or more respective bypass diodes.

Subsequently, an interconnection terminal or busbar 700 is introduced into each window 215. A portion of each busbar 700 is fixed by means of soldering or other technique to the surface of connecting circuit 220c left exposed by hole 215 formed in substrate 210 of back-contact back-sheet 200. The operation briefly described above entails considerable technical problems.

For example, the operation of forming windows 215 is critical in that substrate 210 must be pierced with an extreme precision, so as to expose connecting circuit 220c, while simultaneously ensuring that the portion of circuit 220c to be exposed is not damaged during the operation of opening the windows. Therefore, when forming windows 215, an excess of ablation of substrate 210 should be avoided, which would cause connecting circuit 220c to be undesirably damaged or eroded. An undesired ablation of connecting circuit 220c would turn out to be particularly detrimental due to the limited thickness of connecting circuit 220c, usually in the range of 25 µm to 70 µm. On the other hand, if the ablation performed in order to form windows 215 is not deep enough, the entire thickness of insulating substrate 210 cannot be ablated and a residual insulating layer would remain in correspondence to windows 215 on the surface of connecting circuit 220c facing substrate 210. This would hinder the electrical contact with circuit 220c.

A solution has been proposed in the Italian Patent Application having filing number VI2012A000292 consisting in using the process of mechanical milling for forming windows 215 in substrate 210 of back-contact back-sheet 200. Although this method permits a remarkable precision when engraving substrate 210, controlling the mills in order to reach the desired ablation depth requires rather sophisticated and not trivial techniques.

Furthermore, it may be hard to fix busbars 700 to connecting circuit 220c. For example, it may well be difficult to fix an end of busbar 700 to connecting circuit 220c within a window 215, since it might be hard to reach the portion of lower surface of connecting circuit 220c exposed towards window 215. It should be understood that it is crucial to reliably fix busbars 700 to the connecting circuit, in order to ensure that the electric contact between the two elements is as effective as possible.

Attaching busbars 700 to connecting circuit 220c is particularly critical when the two elements to be attached to each other comprise aluminum. In this case, the traditionally used techniques include brazing or braze welding processes requiring high temperatures. However, excessively heating the back-contact back-sheet is extremely undesirable, in that this could result in profile bending which would jeopardize the reliability of the back-contact back-sheet inside the photovoltaic module.

In the Italian patent application filing number VI2012A000292, published as ITV120120292 A1, a solution has been proposed as an alternative to aluminum brazing. The solution consists of using spot welding or ultrasonic welding, which restricts application of heat to extremely small areas of the back-contact back-sheet. However, these techniques require application of electrodes or sonotrodes which might be hard to apply to a busbar 700 through a window 215. It should be also considered that spot welding or ultrasonic welding are hard to be used when two components have to be joined with thicknesses ranging from a few tenths to a few hundredths of micrometers, such as in the typical case of busbars 700 to be joined to a connecting circuit 220c.

Furthermore, when the connecting circuit is implemented in aluminum, according to common technique, the aluminum surface is covered by a protective thin metal film in order to prevent the exposed surface of the circuit from oxidizing, thereby permitting a correct electrical connection to the photovoltaic cell through electrically conductive paste ECA. This plating technique, rather costly and cumbersome, should be repeated on the lower surface of the conductor in order to permit an easy connection with the busbars. However, due to the high cost involved, metallization of the lower surface of the aluminum layer is preferably omitted.

A backsheet for backcontact solar cell is disclosed in HANITA COATINGS:
"DuraShield Back-Contact Sheets",INTERNET CITATION, 13 June 2012 (2012-06-13), pages 1-2, XP002712000,Retrieved from the Internet:URL:http://www.hanitaenergy.com/ sites/hanita/UserContent/files/PV%20PDF/PV_BACKCONTACT_page_v5.pdf

In view of the mentioned problems and the drawbacks described above, an object of the present invention is to provide a back-contact back-sheet and a method of manufacturing thereof, such that the electrical contact between the busbars and the connecting circuit may be implemented in an effective, fast and reliable manner, thus obviating the problems referred to above and related to the prior art.

### SUMMARY OF THE INVENTION

According to the present invention, a back-contact back-sheet and a method of manufacturing thereof are proposed, based on the concept that a connecting terminal may contact the connecting circuit on the upper surface of the circuit, i.e. on the surface opposite the surface fixed to the substrate of the back-contact back-sheet.

Based on these considerations, a back-contact back-sheet for photovoltaic modules as claimed in independent claim 1 is proposed. The back-contact back-sheet according to the present invention comprises a region indented towards the air-side of the photovoltaic module. The indentation is formed in a portion of the back-contact back-sheet comprising the connecting circuit. A through-hole is then formed within the indented region. The through-hole brings into communication the surface of the connecting circuit exposed towards the inside of the photovoltaic module with the face of the back-contact back-sheet facing the air-side of the photovoltaic module.

A transport portion of a connecting element, e.g. a rivet stem, can be inserted into the through-hole in such a way that the contact portion of the connecting element, e.g. the head of the rivet, is attached to and in electrical contact with the surface of the connecting circuit exposed towards the inside of the photovoltaic module. The connecting element thus allows the photovoltaic module in which the back-contact back-sheet is included to exchange an electrical signal with the outside. For example, current coming from another photovoltaic module in the plant may be brought into the photovoltaic module wherein the back-contact back-sheet is included. Furthermore, the current collected from the connecting circuit may be transferred outside of the photovoltaic module and sent to a junction-box.

The contact portion of the connecting element can then be housed in the cavity defined by the indented region.

The size dimensions of the indented region can be chosen based on the size dimensions of the contact portion of the connecting element. In particular, the size dimensions of the indented region can be chosen so as to be slightly greater than the respective size dimensions of the contact portion. Thus, the contact portion of the connecting element (e.g. the rivet head) may be attached to the portion of connecting circuit included in the indented portion in such a way that, given a cross-section of the system comprising the back-contact back-sheet and the connecting element attached thereto, the contact portion of the connecting circuit is completely included in the cavity defined by the indented region.

Furthermore, the depth of the cavity defined by the indented region can be advantageously chosen based on the thickness of the contact portion of the connecting element. In particular, the cavity defined by the indented region can be formed so that its depth is equal to or slightly greater than the thickness of the contact portion of the connecting element. In this manner, when the connecting element is attached to the back-contact back-sheet in the final operating position, the surface of the contact portion of the connecting element exposed towards the outside lies on the same plane as that defined by the portion of the inner face of the back-contact back-sheet not included in any indented regions. In other words, the system comprising the back-contact back-sheet and the connecting element exposes towards the inside of the photovoltaic module a substantially flat surface.

In this manner, no tensions can arise due to non-planarity of the surface of the back-contact back-sheet. This type of tensions may cause the cell to be damaged when subject to lamination pressure.

The present invention further proposes the method of manufacturing a photovoltaic module as claimed in claim 14.

Preferred embodiments of the present invention are provided by the dependent claims and by the following description.

### BRIEF DESCRIPTION OF THE FIGURES

Further features and advantages of the present invention will appear more clearly from the following description of the embodiments of the device and method according to the present invention shown in the figures. In the figures identical and/or similar and/or corresponding parts are identified by the same reference numerals or letters. In particular, in the in the figures:
Figure 1 shows a perspective exploded view of a portion of a photovoltaic module comprising back-contact cells;
Figure 2a shows a cross-sectional view of the structure of a photovoltaic module of the type shown in Figure 1 before the lamination process;
Figure 2b shows a cross-sectional view of a photovoltaic module of the type shown in Figure 1 after the lamination process;
Figure 3 shows a cross-sectional view of a back-contact back-sheet according to the prior art;
Figure 4 shows a cross-sectional view of a back-contact back-sheet according to an embodiment of the present invention in an intermediate stage of the manufacturing process;
Figure 5 shows a cross-sectional view of a back-contact back-sheet according to a further embodiment of the present invention in an intermediate stage of the manufacturing process;
Figure 6 shows a cross-sectional view of a back-contact back-sheet according to an embodiment of the present invention in a more advanced manufacturing process stage than that shown in Figure 4 and in Figure 5;
Figure 7a shows a top view of a back-contact back-sheet according to an embodiment of the present invention in the manufacturing process stage shown in Figure 6;
Figure 7b shows a bottom view of a back-contact back-sheet according to an embodiment of the present invention in the manufacturing process stage shown in Figure 6;
Figure 8 shows an enlarged top view of a back-contact back-sheet according to an embodiment of the present invention in a non-final stage of the manufacturing process;
Figure 9a shows a front view of a connecting element adapted to be used in conjunction with a back-contact back-sheet according to an embodiment of the present invention;
Figure 9b shows the connecting elment shown in Figure 9a after a first portion thereof has been bent with respect to a second portion;
Figure 10a shows a perspective view of a system comprising a back-contact back-sheet according to an embodiment of the present invention in a non-final manufacturing process stage and a connecting element cooperating with the back-contact back-sheet;
Figure 10b shows a cross-sectional view of a system comprising a back-contact back-sheet according to an embodiment of the present invention and a connecting elment cooperating with the back-contact back-sheet;
Figure 11 shows a bottom view of a system comprising a back-contact back-sheet according to an embodiment of the present invention and a connecting element cooperating with the back-contact back-sheet, after the connecting element has been appropriately bent;
Figure 12 shows a cross-sectional view of a portion of a photovoltaic module including a back-contact back-sheet according to the present invention;
Figure 13 shows a cross-sectional view of a portion of a photovoltaic module including a back-contact back-sheet and an external connecting element according to a further embodiment of the present invention;
Figure 14 shows a stage of the method of manufacturing a back-contact back-sheet according to an embodiment of the present invention.

### DETAILED DESCRIPTION

In the following, the present invention will be described with reference to particular embodiments as shown in the attached figures. However, the present invention is not restricted to the particular embodiments described in the following detailed description and shown in the figures. Rather, the described embodiments simply show several aspects of the present invention whose scope is defined by the claims.

Further modifications and variations of the present invention will be clear for the person skilled in the art. Consequently, the present description is to be considered as comprising all modifications and/or variations of the present invention, whose scope is defined by the claims.

The attached figures show a right-handed system of Cartesian axes, wherein the oriented z-axis indicates the vertical direction and the xy-plane should be understood as a horizontal plane, orthogonal to the direction of the z-axis. Therefore, a direction, an axis, or a plane will be referred to as "vertical" ("horizontal") when parallel (orthogonal) to the direction of the z-axis.

In the following and in the whole application, local expressions such as "above" or "bellow" are always referred to an oriented axis indicating the vertical direction. Therefore, given a system of three Cartesian axes wherein the z-axis indicates the vertical direction, the expression "point A above (below) point B" should be understood as expressing the concept that the segment included in the z-axis and oriented in the direction going from the orthogonal projection of point B onto the z-axis to the orthogonal projection of point A onto the z-axis lies along the same direction as (the opposite direction to) the direction of the z-axis. Furthermore, when a constituent part or an object are defined as "upper", thus implicitly comparing them to a second "lower" constituent part or object, it should be understood that the upper constituent part or object lie above the lower constituent part or object.

Analogously, local expression such as "up" or "down" should always be referred to a reference system of Cartesian axes shown in the figures. Thus, the expression "upwards" ("downwards") will indicate a direction or an axis with the same direction as (the opposite direction to) the direction of z-axis.

The back-contact back-sheet according to the present invention is an evolution of the back-contact back-sheet already proposed in the previous Italian patent applications having reference numbers VI2012A000132 and VI2012A000264.

The back-contact back-sheet according to the present invention is substantially planar. In the figures from 6 to 12, the back-contact back-sheet, or a major portion thereof, extend across a substantially parallel plane parallel to the xy-plane.

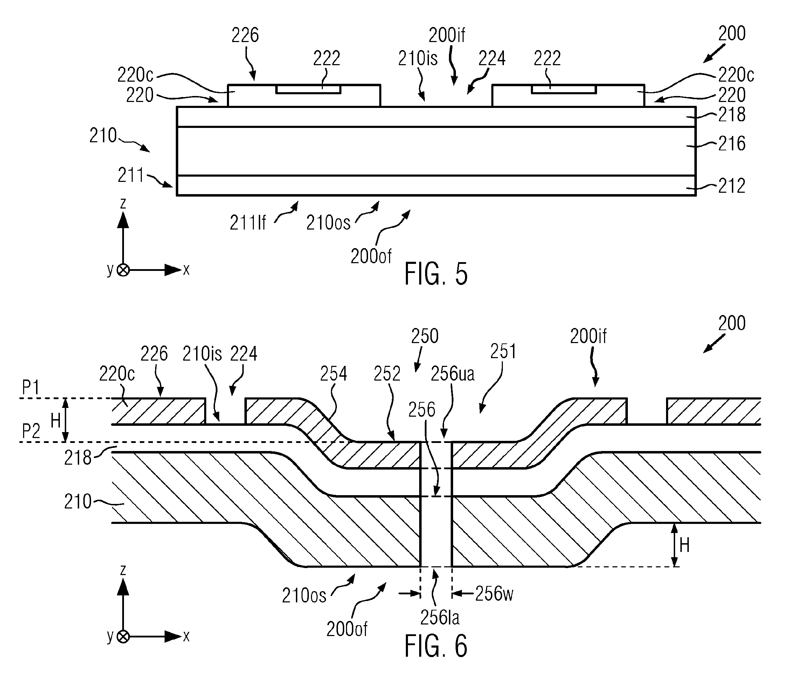

Figures 4 and 5 show the back-contact back-sheet 200 according to two respective embodiments of the invention in an intermediate stage of the manufacturing process.

The air-side of the photovoltaic module is the side at the bottom of Figures 4 and 5, below the back-contact back-sheet 200 shown therein.

With reference to Figure 4, back-contact back-sheet 200 comprises an outer face 200of facing the air-side of the photovoltaic module and an inner face 200if opposite the outer face 200of and exposed towards the inside of the photovoltaic module.

Back-contact back-sheet 200 further comprises an insulating complex or substrate 210 exposed to the air-side of the photovoltaic module, as well as an electrically conductive material layer 220.

Insulating substrate 210 has an outer surface 210os facing the air-side of the photovoltaic module and substantially coincident with the outer face 200of of back-contact back-sheet 200. Furthermore, substrate 210 has an inner surface 210is opposite outer surface 210os and facing the inside of the photovoltaic module.

In the embodiment of the back-contact back-sheet shown in Figure 4, insulating substrate 210 comprises a first insulating layer 212 and a second insulating layer 216.

The first insulating layer 212 has a surface exposed toward the air-side of the photovoltaic module substantially coincident with outer surface 210os of substrate 210. First insulating layer 212 is used as a barrier against moisture, UV rays, oxygen and other external environmental agents which might penetrate into the module, thereby damaging some constituent parts thereof or causing the polyurethane-like or polyester-like adhesive to degrade and turn yellow. First insulating layer 212 may comprise a polymer such as polyvinyl fluoride (PVF), polyvinylidene fluoride (PVDF), polyethylene terephtalate (PET), or other polymers. First insulating material 212 may also comprise other materials known in the state of the art. First insulating layer 212 may have a thickness in a range of approximately 25 to 75 µm or greater.

The second insulating layer 216 is then applied to the inner surface of first insulating layer 212, opposite the surface exposed to the air-side. Second insulating layer 216 acts as an electrical insulator and a further barrier. Second insulating layer 216 typically comprises a polymer such as, for example, polyethylene terephtalate (PET), polyethylene (PE), polyvinyl fluoride (PVF), polyvinylidene fluoride (PVDF), polyethylene naphtalate (PEN), polyimide (PI), or the like. Second insulating layer 216 may have a thickness in the range of approximately 125 to approximately 350 µm or greater.

In other embodiments not shown in the figures, insulating substrate 210 is comprised of a single layer comprising, for example, one or more polymers such as PET, PE, PVF, PVDF, PEN, PI, similar polymers and combinations thereof.

According to a further embodiment shown in Figure 5, substrate 210 of back-contact back-sheet 200 comprises an insulating portion 211 and a primer layer 218 applied to insulating portion 211. Primer layer 218 and insulating portion 211 of substrate 210 have been described in the earlier Italian patent application having filing number VI2012A000264. In the following, only a brief summary of this embodiment will be provided.

Insulating portion 211 of substrate 210 comprises a lower face 211lf exposed towards the air-side of the photovoltaic module and substantially coincident with outer surface 210os of substrate 210 and, thus, with outer face 200of of backc-contact back-sheet 200. Insulating portion 211 further comprises an upper face opposite lower face 211lf. Insulating portion 211 may be implemented in any of the ways in which substrate 210 can be implemented according to the embodiments described above with reference to Figure 4.

In particular, according to the embodiment shown in Figure 5, insulating portion 211 comprises a first insulating layer 212 and a second insulating layer 216. Layers 212 and 216 according to the embodiment shown in Figure 5 have analogous or identical features and functionalities to, respectively, layers 212 and 216 described with respect to the embodiment shown in Figure 4. Consistently with what has been described above in relation to the embodiment of Figure 4, according to other embodiments insulating portion 211 may comprise a single layer. The single layer or one or more of the plurality of layers making up insulating portion 211 may comprise one or more materials such as, for example, PET, PE, PVF, PVDF, PEN, PI, like polymers and combinations of the previous materials.

Primer layer 218 is applied to the upper surface of insulating portion 211, opposite lower face 211lf, so that the inner face of primer layer 218, opposite the face facing insulating portion 211, substantially coincides with inner surface 210is of substrate 210. Primer layer 218 is arranged between lower insulating portion 211 of substrate 210 and conductive material layer 220 within which connecting circuit 220c is formed.

Primer layer 218 may be deposited by means of extrusion coating onto the upper face of the lower insulating portion 211. Primer layer 218 may also be attached by using an adhesive system. Primer layer 218 has a thickness in the range of about 50 to about 350 µm and, preferably, in the range of about 50 to about 150 µm. Primer layer 218 carries out the main task of guaranteeing an improved adhesion of inner face 200if of the back-contact back-sheet with encapsulating material layers 400 and 450 shown in Figure 1 and/or with a thermoadesive material, which are to be applied thereupon.

Primer layer 218 thus comprises materials which are chemically or functionally akin to the materials constituting the encapsulating material layers 400 and 450 shown in Figures 1, 2a and 2b. Primer layer 218 may thus comprise EVA (for example EVA with a content of vinyl acetate variable in the range of 3% to 5%), linear low density polyethylene (LLDPE), linear high density polyethylene (LHDPE), polyolefins or combinations thereof. Alternatively,
primer layer 218 may comprise one or more thermo-adhesive materials. For example, primer layer 218 may comprise one or more of the following materials: acryl polymers or polyurethanes loaded with additives, acryl terpolymers grafted with maleic anhydride.

As shown in Figures 4 and 5, back-contact back-sheet 200 comprises an electrically conductive material layer 220 applied to inner surface 210is of insulating substrate 210, so that layer 220 is firmly attached to insulating substrate 210. Conductive material layer 220 comprises a lower surface firmly attached to inner surface 210is of substrate 210 and an upper surface opposite the lower surface and adapted to be exposed towards the inside of the photovoltaic module.

Conductive material layer 220 may have a thickness approximately ranging from 25 to 70 µm. Conductive material layer 220 comprises a metal with a high electrical conductivity such as copper or aluminium. Conductive material layer 220 may also comprise an alloy of copper and aluminium. The advantage with using aluminium instead of copper is substantially due to the lower cost of the former with respect to the latter. However, the problem with aluminium is the oxide layer, known as alumina (Al₂O₃), which promptly forms as an aluminium surface is exposed to gases normally present in the atmosphere at standard pressure. Formation of an oxide layer on the upper surface of conductive layer 220 is particularly undesirable, since this surface of conductive layer 220 is to contact the electrodes of photovoltaic cells 600 through conductive adhesive 300, as describe above with reference to Figures 2a and 2b.

Again with reference to Figures 4 and 5, in order to obviate the problem of oxide formation, a protection thin conductive film can be formed onto the upper surface of conductive material layer 220 adapted to be exposed towards the inside of the photovoltaic module. The protection film is deposited onto the upper surface of conductive material layer 220 in order to prevent layer 220 from oxidizing, thereby improving the electrical contact with the electrodes of the photovoltaic cells. Thus, the protection thin film comprises in general a metal with a high conductivity and not subject to oxidation. For example, if conductive material layer 220 comprises aluminium, the protection thin film may comprise a metal such as, for example, copper, silver, gold. If conductive material layer 220 comprises instead copper, a protection conductive film comprising a metal such as, for example, nickel or tin may be formed on the surface of layer 220. The protection film of an electrically conductive material may be applied by following the procedure described in the earlier Italian patent application with filing number VI2012A000266 and briefly illustrated in the following.

A connecting circuit 220c is formed within conductive material layer 220. Circuit 220c is comprised of metallic paths separated by channels 224. As previously said, connecting circuit 220c is adapted to be brought into contact with both electrodes, i.e. with both base and emitter, of solar cells 600. In particular, pads 222 formed on conductive material paths mark the points of connecting circuit 220c which are to be electrically connected to an electrode contact formed on the surface of cell 600.

Still with reference to Figures 4 and 5, the lower surface of connecting circuit 220c facing insulating substrate 210 is a portion of the lower surface of conductive layer 220. Similarly, the upper surface 226 of connecting circuit 220c, opposite the lower surface and exposed towards the inside of the photovoltaic module, is a portion of the upper surface of conductive material layer 220.

Upper surface 226 of connecting circuit 220c may comprise a protective film of an organic material (Organic Solderability Preservative) not shown in the figures. The organic protective film, aimed at protecting the exposed surface 226 of the connecting circuit from abrasion and chemical reactions with external agents, is particularly advantageous when the connecting circuit comprises copper.

Figures 4 and 5 show that, after connecting circuit 220c has been formed in conductive layer 220, inner face 200if of back-contact back-sheet 200 comprises upper surface 226 of connecting circuit 220c and the portion of inner surface 210is of substrate 210 left exposed by channels 224 defined by adjacent paths of connecting circuit 220c.

Back-contact back-sheet 200 resulting from the intermediate stage of manufacturing shown in Figures 4 and 5 has a substantially planar shape across its entire extension. That is to say, outer surface 210os of substrate 210, inner surface 210is of substrate 210 and outer surface 226 of connecting circuit 220c lie each on a single respective plane, without forming any indentations or steps. The planes defined by the surfaces mentioned above are parallel to each other and, in Figures 4 and 5, are parallel to the horizontal xy-plane.

Figure 6 schematically shows a cross-section taken across a vertical plane parallel to the xz-plane of the back-contact back-sheet 200 according to the present invention in its final form. The substrate 210 of the back-contact back-sheet shown in Fig. 6 may be implemented in any of the ways described above with reference to Figures 4 and 5. In the embodiment shown in Figure 6, substrate 210 comprises a primer layer 218 applied on top of a lower-lying insulating portion. Furthermore, connecting circuit 220c is formed within conductive material layer 220 as indicated above with reference to Figures 4 and 5.

Back-contact back-sheet 200 shown in Figure 6 comprises an indented portion 250. The portion of inner face 200if of back-contact back-sheet 200 included in indented region 250 forms an indentation facing the air-side of the photovoltaic module. Thus, in correspondence to indented region 250, inner face 200if of back-contact back-sheet 200 forms a concavity facing the inside of the photovoltaic module, i.e. a concavity facing upwards with respect to the reference system of Figure 6. More precisely, the upper surface 256 of connecting circuit 220c and the inner surface 210is of substrate 210 form, in correspondence to indented region 250, respective cavities facing upwards.

Thus, in correspondence to an indented region 250, inner face 200if of back-contact back-sheet 200 defines a cavity 251 which, when back-contact back-sheet 200 is embedded in the photovoltaic module, communicates with the inner space of the photovoltaic module.

According to the embodiment shown in Figure 6, outer face 200of also forms a concavity facing upwards in correspondence to indented region 250.

Indented region 250 is formed in correspondence to connecting circuit 220c and so as to include a portion thereof. Thus, the portion of inner face 200if of back-contact back-sheet 200 included in indented region 250 comprises a portion of connecting circuit 220c. More precisely, the portion of inner face 200if of back-contact back-sheet 200 included in indented region 250 comprises a portion of upper surface 226 of connecting circuit 220c.

Preferably, the whole portion of inner face 200if of back-contact back-sheet 200 included in indented region 250 includes a portion of connecting circuit 220c. That is to say, the portion of inner face 200if of back-contact back-sheet 200 included in indented region 250 does not preferably contain any portions of inner surface 210if of substrate 210.

Figure 6 shows that the portion of inner face 200if included in indented region 250 is entirely comprised of a portion of connecting circuit 220c. When for the sake of simplicity it is said that conductive material layer 220 or connecting circuit 220c form a concavity or a cavity facing upwards, it will be assumed that upper surface 226 and the lower surface of connecting circuit 220c are substantially parallel, since connecting circuit 220c is formed from a thin, flexible film wherein the distance between upper surface 226 and the lower surface remains substantially constant.

Indented region 250 comprises a first, substantially flat portion 252, which lies on a substantially horizontal plane P2. More precisely, the portion of upper surface 226 of connecting circuit 220c included in substantially flat portion 252 of indented region 250 lies on a substantially horizontal plane P2 parallel to the xy-plane. Furthermore, the inner surface 210is of substrate 210 included in substantially flat portion 252 of indented region 250 also lies on a plane parallel to plane P2 and, thus, on a substantially horizontal plane.

According to the embodiment shown in Figure 6, the portion of outer surface 210os of substrate 210 included in indented region 250 lies also on a plane parallel to horizontal xy-plane. Flat portion 252 occupies a central area of indented region 250.

Indented region 250 shown in Figure 6 further comprises a second, curved portion 254. Curved portion 254 surrounds flat portion 252 and connects it to the non-indented region of the back-contact back-sheet 200 situated around and outside indented region 250. Curved region 254 is such that a tangent plane to a point of inner face 200if of back-contact back-sheet 200 belonging to curved region 254 forms an angle different from zero with the horizontal xy-plane.

One can observe that the region of back-contact back-sheet 200 not included in any indented regions 250 is substantially planar, as indicated with reference to Figures 4 and 5. Furthermore, again with reference to Figure 6, the portion of inner face 200if of back-contact back-sheet 200 not included in any indented regions 250 lies on a substantially horizontal plane P1 lying above any given point of inner face 200if belonging to indented region 250. In an analogous manner, according to the embodiment shown in Figure 6, the portion of outer face 200of of back-contact back-sheet 200 not included in any indented regions 250 lies on a substantially horizontal plane lying above any point belonging to the portion of outer face 200of included in an indented region 250.

In particular, Figure 6 shows that horizontal plane P2, defined by the portion of upper surface 226 of connecting circuit 220c included in flat portion 252 of indented region 250, lies below horizontal plane P1, defined by the portion of upper surface 226 of connecting circuit 220c not included in any indented regions 250. The distance between planes P1 and P2, indicated in Figure 6 by reference letter H, determines the depth of indented region 250 with respect to the non-indented region of back-contact back-sheet 200.

Figure 6 shows that the thickness of back-contact back-sheet 200 is substantially constant in each portion thereof. Therefore, outer face 200of of back-contact back-sheet 200 has a profile having a correlated curvature to the curvature of inner face 200if. Thus, According to the embodiment shown in Figure 6, indented region 250 extends through the entire thickness of back-contact back-sheet 200. That is to say, according to the embodiment shown in Figure 6, indented region 250 extends vertically from inner face 200if to outer face 200of of back-contact back-sheet 200.

In particular, Figure 6 shows that the portion of outer face 200of of back-contact back-sheet included in indented region 250 lies on a horizontal plane placed below the plane defined by the portion of outer face 200of of the back-contact back-sheet not included in any indented regions 250. The distance H between the two planes is the same as the distance between the planes P1 and P2. Therefore, according to the embodiment shown in Figure 6, indented region 250 forms a protruding element on outer face 200of of back-contact back-sheet 200. The height of the protruding element is determined by depth H of cavity 251 defined by inner face 200if of back-contact back-sheet 200 in correspondence to indented region 250.

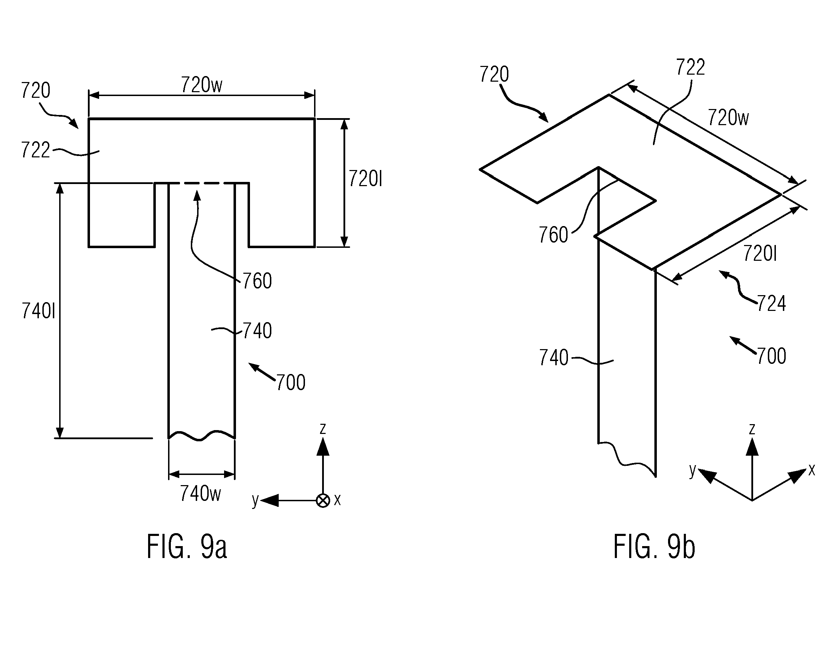

As will be more clearly explained in the following with reference to Figures 9a-12, indented region 250 is adapted to house a contact portion 720 of a connecting element 700. Indented region 250 is thus adapted to permit an electric contact between contact portion 720 of a connecting element 700 and connecting circuit 220c. Furthermore, contact portion 720 of connecting element 700 may advantageously be attached to the portion of upper surface 226 of connecting circuit 220c included in indented region 250, as will be described more extensively in the following.

Again with reference to Figure 6, distance H determining the depth of cavity 251 is preferably included in the range of about 100 µm to about 800 µm. As will be explained in the following, distance H may advantageously be chosen equal or slightly greater than the thickness of contact portion 720 of connecting element 700 chosen for cooperating with back-contact back-sheet 200.

Still with reference to Figure 6, the back-contact back-sheet 200 according to the present invention further comprises a through-hole 256, formed within indented portion 250. Hole 256 is advantageously formed within flat portion 252 of a respective indented region 250. Yet more in detail, hole 256 is advantageously formed in a central area of flat portion 252 of indented region 250.

According to other embodiments and depending on the shape and dimension of connecting element 700, hole 256 may also advantageously be formed in a non-central position.

Through-hole 256 is formed through the thickness of back-contact back-sheet 200 so as to extend from upper surface 226 of connecting circuit 220c to outer face 200of of back-contact back-sheet 200. It should be noticed that through-hole 256 is preferably formed in an area of back-contact back-sheet 200 such that a part of hole 256 is formed within connecting circuit 220c. Therefore, hole 256 is preferably formed so that it does not communicate with a channel 224 between two adjacent paths of connecting circuit 220c.

As will be clarified in the following with reference to Figures 9a-12, hole 256 is adapted to house a transport portion 740 of a connecting element 700, so as to allow the electrical current collected from connecting circuit 220c to be transferred outside of the photovoltaic module.

Again with reference to Figure 6, through-hole 256 has a longitudinal axis which is preferably parallel to the vertical z-axis and extends through the whole thickness of back-contact back-sheet 200. Thus, hole 256 communicates with the air-side of the photovoltaic module by means of lower aperture 2561a formed in outer face 200of of back-contact back-sheet 200. Furthermore, hole 256 communicates with the space included inside the photovoltaic module through upper aperture 256ua formed in upper surface 226 of connecting circuit 220c. In particular, hole 256 communicates, through upper aperture 256ua, with cavity 251 defined by the portion of inner face 200if of back-contact back-sheet 200 included in indented region 250.

As shown in Figure 6, hole 256 extends across the horizontal x-axis by a width 256w. Preferably, width 256w of hole 256 is in the range of about 500 µm to about 1000 µm. As will be clarified in the following, width 256w of hole 256 can be chosen so as to adapt to the thickness of transport portion 740 of connecting element 700 housed therein.

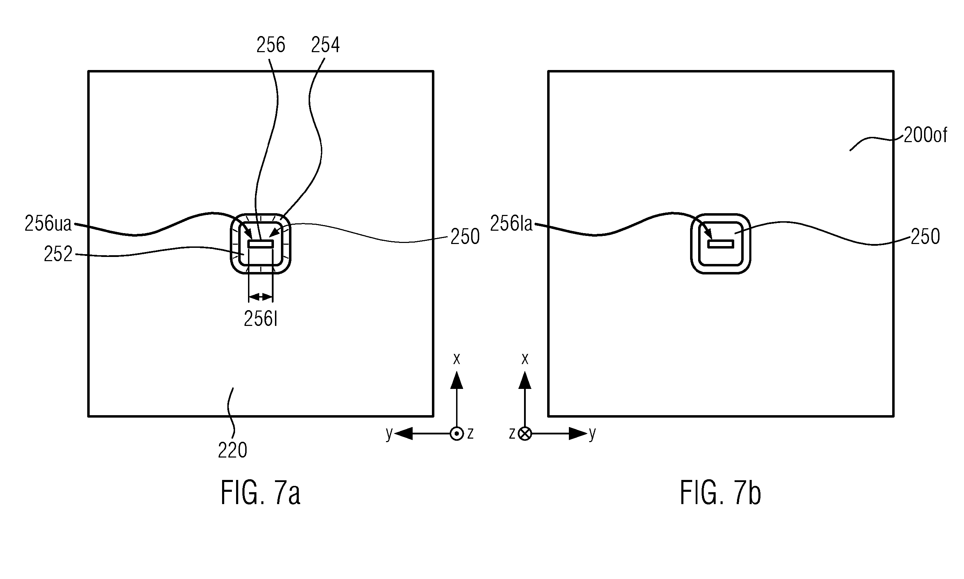

Figures 7a and 7b show, respectively, a top view and a bottom view of a back-contact back-sheet 200 according to the present invention comprising indented region 250. According to the embodiment shown in Figure 7a, indented region 250 is formed before processing conductive material layer 220 in order to form connecting circuit 220c. Therefore, the back-contact back-sheet shown in Figures 7a and 7b is in an intermediate stage of the manufacturing process. Figure 7a shows in particular that conductive material layer 220 applied to substrate 210 is formed as a full and continuous layer, whose surface does not have meanders, channels or interruptions, except for hole 256.

The only interruption of conductive layer 220 shown in Figure 7a is hole 256 formed within indented region 250. Figure 7a shows that hole 256 extends along the y-axis by a length 256l. Length 256l of hole 256 may preferably vary in the range of a few millimetres to a few tens of millimetres.

Figure 7b shows that outer face 200of of back-contact back-sheet 200 forms a relief or a protruding portion in correspondence to indented region 250.

The height of the relief formed by indented region 250 on outer face 200of corresponds and is about equal to depth H of cavity 251 formed by inner face 200if in correspondence to indented region 250.

In the following, the expression "upper surface" of indented region 250 will indicate the portion of inner face 200if of the back-contact back-sheet included in indented region 250. Analogously, the expression "lower surface" of indented region 250 will indicate the portion of outer face 200of of the back-contact back-sheet included in indented region 250.

According to the embodiment shown in Figures 7a and 7b, the upper surface and the lower surface of indented region 250 have a substantially square shape. More specifically, Figure 7a shows that the portion of inner face 200if of back-contact back-sheet 200 included in indented region 250 is substantially square. Furthermore, Figure 7b shows that the portion of outer face 200of of back-contact back-sheet 200 included in indented region 250 is substantially square.

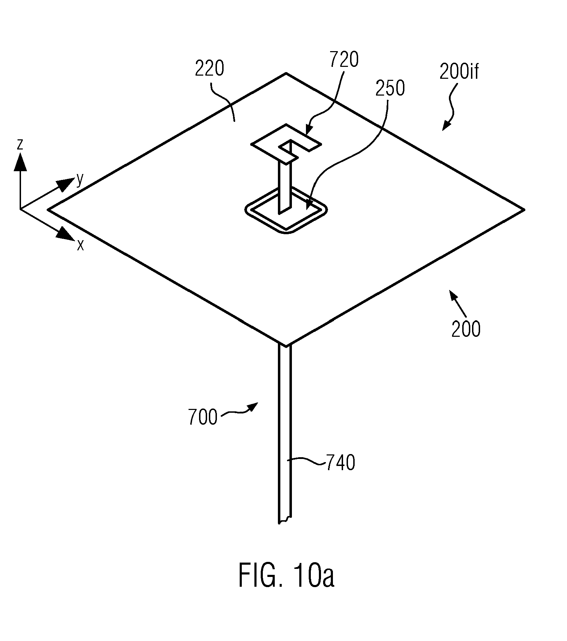

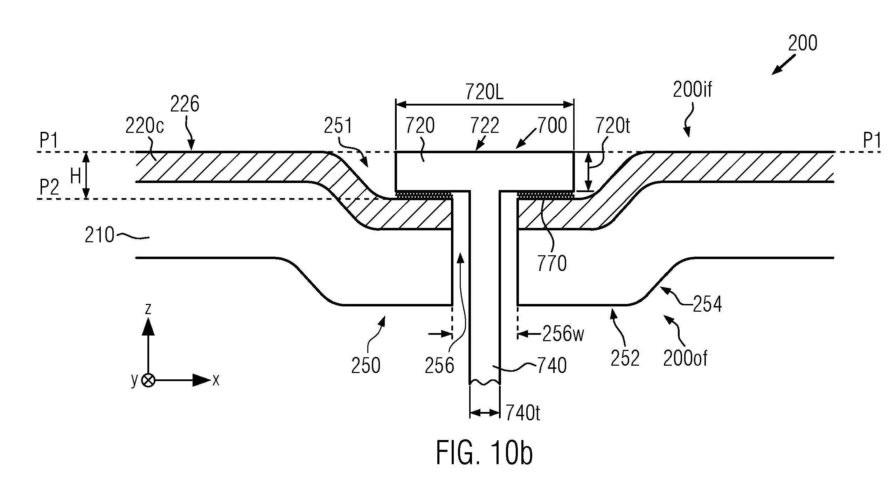

In other embodiments not shown in the figures, indented region 250 has an upper surface or a lower surface having a form different from a square. In particular, the indented region may have, depending on usage requirements, the shape of a circle, a regular polygon, an irregular polygon. In particular, the shape of the upper surface of indented region 250 may be advantageously chosen based on the shape of contact portion 720 of connecting element 700 to be used in cooperation with the considered indented region 250, as will be explained in the following with reference to Figures 10a and 10b.

Again with reference to Figures 7a and 7b, the upper surface of indented region 250 extends preferably across an area ranging from approximately 20 to 80 mm². As a general rule, the upper surface of indented region 250 has preferably an area sufficient to guarantee a current density compatible with the features of the chosen connecting element 700 and conductive connecting system. More in detail, the upper surface of indented region 250 preferably extends across an area ranging from approximately 30 to 70 mm². If the upper surface of indented region 250 is square, the square side has preferably a length of 6 mm or 8 mm. Thus, the area of the upper surface of indented region 250 is preferably of about 36 mm² or 64 mm². However, in other embodiments the area of the upper surface of indented region 250 may be less than 20 mm² or greater than 80 mm², depending on the requirements and, in particular, depending on the shape and the size of contact portion 720 of connecting element 700 to be used in cooperation with back-contact back-sheet 200 and with indented region 250.

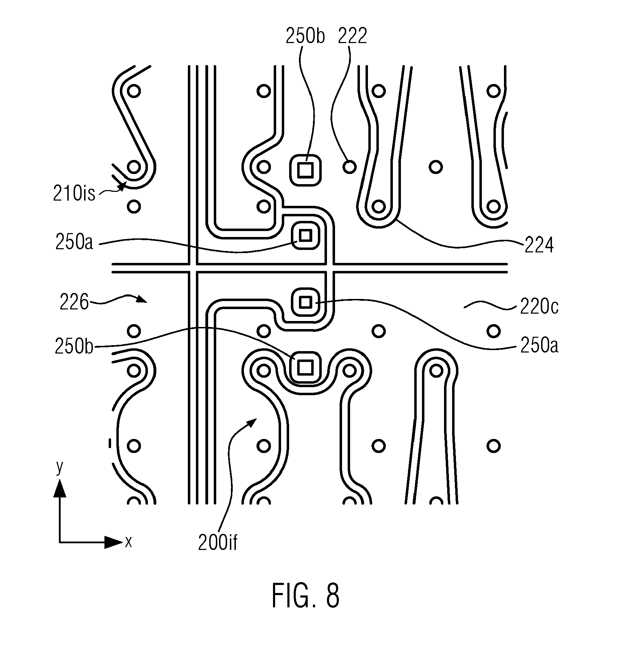

Figure 8 shows a top view of a portion of a back-contact back-sheet 200 according to an embodiment of the invention in an intermediate stage of the manufacturing process. In particular, Figure 8 shows a portion of inner face 200if of back-contact back-sheet 200 in a non-final stage of the manufacturing process.

According to the embodiment shown in Figure 8, connecting circuit 220c exposing upper surface 226 towards the outside has been formed within conductive material layer 220. In the figure, the conductive material paths delimited by channels 224 are visible. Channels 224 leaves some portion of inner surface 210is of substrate 210 exposed. On upper surface 226 of connecting circuit 220c pads 222 are formed, which are adapted to electrically contact the electrodes of the photovoltaic cells.

Figure 8 also shows that four indented regions 250a and 250b have been formed in the back-contact back-sheet. In particular, indented regions 250a and 250b are formed in correspondence to portions of inner face 200if of the back-coontact back-sheet occupied by connecting circuit 220c. More specifically, all four indented regions 250a and 250b are formed so that their respective surface portions included in inner face 200if of back-contact back-sheet 200 are entirely included in one of the conductive paths forming connecting circuit 220c. In other words, the portion of inner face 200if of back-contact back-sheet 200 included in each indented region 250a and 250b, i.e. the upper surface of each indented region 250a and 250b, is exclusively comprised of a respective portion of upper surface 226 of connecting circuit 220c.

Two of the four indented regions, for example the two regions 250b, may be used as points of connecting circuit 220c through which an electrical signal can be exchanged with the outside of the photovoltaic module. The two remaining indented regions, for example regions 250a, may then be used so as to permit an electrical connection to electrical components or apparatuses outside the photovoltaic module. For example, each of the two remaining indented regions may be adapted to be connected to a respective diode. Typically, the diode is a by-pass diode. It is pointed out that the upper surface of indented regions 250a is smaller than the upper surface of indented regions 250b. For example, the upper surface of indented regions 250a may be approximately square, with the square formed by each indented region 250a having a size length of about 6 mm. The upper surface of indented regions 250b may also be approximately square, with the square formed by each indented region 250b having a size length of about 8 mm.

According to the present invention, the number of indented regions 250 formed in back-contact back-sheet 200 is at least two. However, the indented regions 250 do not necessarily have to be four. In general, any number equal to or greater than two of indented regions 250 may be formed in back-contact back-sheet 200.

During the manufacturing stage of back-contact back-sheet 200 according to the present invention following the stage shown in Figure 8, a through-hole 256 is formed in each indented region 250a and 250b. In this manner, back-contact back-sheet 200 takes its final form shown in Figure 6.

Figures 9a to 11 show some examples of how a connecting element 700 may cooperate with the back-contact back-sheet 200 according to the present invention, in order to allow the photovoltaic module including back-contact back-sheet 200 to exchange an electric signal with the outside.

Figures 9a and 9b show an example of a connecting element 700 which may be used so as to cooperate with back-contact back-sheet 200 according to the present invention. Connecting element 700 comprises a contact portion 720 and a transport portion 740 connected to contact portion 720. Contact portion 720 and transport portion 740 are connected by means of a connecting portion 760.

Connection portion 760 is arranged between contact portion 720 and transport portion 740 so as to allow one to distinguish between contact portion 720 and transport portion 740. The surface portion of connection portion 760 extends by a width (dimension along the y-axis in Figures 9a and 9b) much greater than its height (dimension along the z-axis in Figures 9a and 9b). The surface portion of connection portion 760 thus extends along a segment belonging to both planes on which contact portion 720 and transport portion 740 lie. In Figures 9a and 9b, the segment defined by the surface portion of connection portion 760 is parallel to the y-axis.

Contact portion 720 is adapted to be attached to upper surface 226 of connecting circuit 220c in correspondence to an indented region 250. Contact portion 720 is attached to connecting circuit 220c so as to be in electrical contact thereto.

Transport portion 740 of connecting element 700 is instead adapted to be partially housed in one of holes 256 and, more exactly, in the hole 256 formed in the indented region 250 in which contact portion 720 of connecting element 700 is attached.

Connecting element 700 is made from a material having a high electrical conductivity. For example, connecting element 700 may comprise a metal such as copper, tinned copper, aluminium, aluminium plated with a noble metal, silver, gold. Connecting element 700 may also comprise a metal alloy, for example an alloy of copper and aluminium.

Connecting element 700 may comprise a rivet such as that shown in Figures 9a and 9b.

In the example shown in figures 9a and 9b, transport portion 740 comprises a stem formed as a thin slab having a length 7401 and a width 740w. Preferably, length 740l and width 740w of transport stem 740 are much greater than its thickness 740t shown in Figure 10b. Again with reference to Figure 9a, transport portion 740 may alternatively comprise an elongated element such as for example a substantially cylindrical body, or in general a body with a longitudinal axis and a cross section chosen depending on the particular needs.

Contact portion 720 of connecting element 700 shown in figures 9a and 9b is substantially planar and it is formed as well as a thin slab. Contact portion 720 thus comprises two main surfaces 722 and 724, opposite one another and having a length 720l and a width 720w. Preferably, length 720l and width 720w of surfaces 722 and 724 are much greater than the thickness 720t of contact portion 720 shown in Figure 10b. Again with reference to Figures 9a and 9b, the width 720w and the length 720l of surfaces 722 and 724 of contact portion 720 may advantageously be chosen so as to guarantee an effective and reliable electrical contact to connecting circuit 220c. For example, typical dimensions of width 720w and length 7201 of surfaces 722 and 724 range from a few millimeters to a few tenths of millimeters.

Preferably, length 7201 and width 720w of surfaces 722 and 724 are approximately equal, thereby making surfaces 722 and 724 of slab 720 substantially square. For example, length 7201 and width 720w may be in the range of approximately 5 to 10 mm. However, main surfaces 722 and 724 of contact portion 720 do not necessarily have to be either square or rectangular. The main surfaces 722 and 724 of contact portion 720 may instead have the shape of any regular or irregular polygon.

It is possible to use contact portions 720 of connecting elements 700 which are not planar. For example, contact portion 720 may comprise a spherical cap, such as in the case of a nail head.

In figure 9a, contact portion 720 and transport portion 740 are substantially coplanar. Figure 9b shows that it is possible to bend connecting element 700 along line 760 connecting portion 720 and transport portion 740. In general, transport portion 740 may be bent by inducing a rotation of transport portion 740 with respect to contact portion 720 about an axis parallel to both respective planes on which contact portion 720 and transport 740 lie and passing through connection portion 760.

For example, in the example shown in figures 9a and 9b, transport portion 740 is rotated with respect to contact portion 720 about an axis parallel to the y-axis. The angle of rotation can assume any value between 0° and 180°. Hence, transport element 740 may be bent so that its longitudinal axis forms a predetermined angle between 0° and 180° with the plane defined by contact portion 720.

Due to this bending, the plane upon which contact portion 720 lies forms an angle different from 0 with the longitudinal axis of transport portion 740. When connecting element 700 is inserted into back-contact back-sheet 200, the angle between the plane defined by contact portion 720 and transport portion 740 is preferably close to 90°, as shown in figure 9b. In this configuration, surface 722 faces upwards and surface 744 faces downwards after bending. Thus, surface 722 and surface 724 will be henceforth referred to as "upper surface" and "lower surface" of contact portion 720, respectively. Lower surface 724 of contact portion 720 faces transport portion 740.

Figures 10a and 10b show an example of how a connecting element 720 may be coupled to a back-contact back-sheet according to the present invention. In particular, connecting element 720 is initially introduced into hole 256 and subsequently attached to upper surface 226 of connecting circuit 220c, as will be described in the following.

With reference to figures 10a and 10b, transport portion 740 of connecting element 700 is inserted into hole 256 included in indented region 250. Figure 10a shows the system comprised of back-contact back-sheet 200 and connecting element 700 after transport portion 740 has been partially inserted into hole 256 with the insertion process not yet completed. Connecting element 700 is inserted from inner face 200if of back-contact back-sheet 200, i.e., from the face of the contact back sheet 200 exposed towards the inside of the photovoltaic module. Preferably, the length 740l of transportation portion 740 of connecting element 700 is greater than the length of hole 256, i.e., greater than the thickness of back-contact back-sheet 200. In this manner, as shown in figure 10a, transport portion 740 sticks out from hole 256 by a given portion of its length after being inserted into hole 256. Therefore, after inserting transport stem 740 into hole 256, a portion thereof is outside of the back-contact back-sheet 200 and in the air-side of back-contact back-sheet 200. Thus, after completing the manufacturing process of the photovoltaic module, a first portion of transport stem 740 is housed in hole 256 and a second portion is outside the photovoltaic module. The portion of stem 740 outside the photovoltaic module may be used for letting into the photovoltaic module a current coming from the outside, or for bringing the current coming from the photovoltaic cells to an appropriate device such as for example a junction box or.

Figure 10b shows that the process of inserting transport 740 of connecting element 700 ends when contact portion 720 abuts onto the portion of upper surface 226 of connecting circuit 220c included in indented region 250. Preferably, lower surface 724 of contact portion 720 facing transport portion 740 abuts onto connecting circuit 220c. Thus, upper surface 722, opposite lower surface 724, is exposed towards the space included in the photovoltaic module.

Still with reference to Figure 10b, hole 256 is preferably situated within the flat portion 252 of indented region 250. Hence, contact portion 720 of connecting element 700 comes into contact with a substantially flat area of upper surface 226 of connecting circuit 220c. Preferably, the substantially flat area onto which contact portion 720 portion abuts lies on the horizontal plane P2.

Contact portion 720 of connecting element 700 may be fixed to upper surface 226 of connecting circuit 220c so as to guarantee an electrical contact between connecting element 700 and connecting circuit 220c. Appropriate fixing means 770 may be provided for this purpose between surface 724 of contact portion 720 and upper surface 226 of connecting circuit 220. For example, fixing means 770 may comprise an electrically conductive adhesive, such as for example ECA. Alternatively or additionally, contact portion 720 may be fixed by means of welding, brazing or braze welding. If contact portion 720 of connecting element 700 and connecting circuit 220c comprise aluminum, techniques such as spot welding or ultrasonic welding may be used, as already described in Italian Patent Application Nr. VI2012A000292.

It should be noted that an advantage of the present invention is the fact that, when inserting a connecting element 700 in a through hole 256 of a respective indented region 250, contact portion 720 is easily accessible, since it is exposed towards the same side of back-contact back-sheet 200 towards which inner face 200if of the back-contact back-sheet 200 is exposed. This is in contrast to the conventional approach, wherein the portion of connecting element 700 to be fixed to connecting circuit 220c is at the bottom of a window formed within a substrate 210 of back-contact back-sheet 200 and, consequently hardly accessible. In particular, if electrodes or sonotrodes are to be applied to contact portion 720 of connecting element 700, this operation can be carried out more easily with respect to the method known in the state of the art, wherein the electrodes or sonotrodes are to be introduced into the windows formed in the substrate of the back-contact back-sheet.

Furthermore, one more advantage offered by the present invention lies in the fact that the electrical connection is established on the upper surface 226 of connecting circuit 220c. The upper surface 226 is commonly designed and processed in order to offer as high a degree of electrical conductivity as possible. This is due to the fact that the upper surface 226 of connecting circuit 220c is responsible for the electrical connection between the circuit 220c and the photovoltaic cells through for example an electrically conductive adhesive such as ECA. Hence, the electrical connection between connecting element 700 and connecting circuit 220c is rendered particularly effective, since it is established on a surface of circuit 220c which is already highly conductive.

Again with reference to figure 10b, it can be noticed that the side dimensions (dimensions across the xy-plane in the figure) of indented region 250 are commensurate to and slightly greater than the side dimensions of conduct portion 720 of connecting element 700, i.e., the length 720l and the width 720w of main surfaces 722 and 7224 of contact portion 720. In particular, as shown in figure 10b, the length, i.e., the dimension along the horizontal x-axis, of cavity 251 formed by indented region 250 is equal to or slightly greater than length 720l of contact portion 720 of connecting element 700. Advantageously, the length of flat portion 252 of indented region 250 is equal to or slightly greater than length 720l of contact portion 720. Furthermore, the width, i.e., the dimension along the horizontal y-axis, of cavity 251 formed by indented region 250 is equal to or slightly greater than width 720w of contact portion 720 of connecting element 700. Advantageously, the width of flat portion 252 of indented region 250 is equal to or slightly greater than width 720w of contact portion 720 of connecting element 700.

In this manner, contact portion 720 and, in particular, main surfaces 722 and 724 are entirely included in cavity 251 defined by indented region 250. More precisely, the orthogonal projection of contact portions 720 onto a horizontal plane is included in the orthogonal projection of indented region 250 onto the same horizontal plane. The property of the system shown in figure 10b described right above may be rephrased in the manner given below, wherein the expression "cross-section" refers to a section across a horizontal plane parallel to the xy-plane. Given a cross section of the system shown in figure 10b passing through contact portion 720, contact portion 720 is entirely included in indented region 250.

Advantageously, main surfaces 722 and 724 of contact portion 720 are included in flat portion 252 of indented region 250. More exactly, the orthogonal projection of contact portion 720 onto a horizontal plane is included in the orthogonal projection of flat portion 252 of indented region 250 onto the same horizontal plane.

Still with reference to figure 10b, the depth H of indentation 251 formed by indented region 250 fits thickness 720t of contact portion 720 of connecting element 700. More specifically, depth H is chosen so as to be equal or slightly greater than thickness 720t of contact portion 720. Thus, depth H of concavity 251 is chosen in such a way that, when connecting element 700 cooperates with back-contact back-sheet 200 as described above, exposed upper surface 722 of contact portion 720 lies on a horizontal plane substantially coincident with plane P1 defined by the portion of upper surface 226 of connecting circuit 220c not included in any indented regions. In this manner, when transport portion 740 is inserted into hole 256 and contact portion 720 is fixed to the portion of circuit 220c included in indented region 250, inner face 200if of back-contact back-sheet 200 is substantially flat everywhere and, in particular, in correspondence to indented regions 250. Hence, the system comprising back-contact back-sheet 200 and connecting element 700 cooperating therewith exposes towards the inside of the photovoltaic module a substantially flat surface lying on plane P1. Several other elements making up the photovoltaic module may be then stacked upon this substantially flat surface. Some of these further elements include lower encapsulating material layer 400, upper encapsulating material layer 450, and upper surface protective layer 800 shown in figures 1, 2a and 2b.

Again with reference to figure 10b, thickness 720t of contact portion 720 and depth H of cavity 251 may vary within a typical range of approximately 100 µm to 800 µm. For example if contact portion 720 has a thickness 720t in the range of about 550 µm to approximately 650 µm, then depth H of concavity 251 formed by indented region 250 may advantageously be in the range of about 600 µm to about 800 µm. In other advantageous embodiments, depth H of cavity 251 is included in the range of about 100 µm to 500 µm, thereby requiring connecting elements 700 with a contact portion 720 having a thickness 720t included in the range of approximately 100 µm to 500 µm.

It should be observed that depth H of cavity 251 may conveniently be as low as allowed by the structural features of connecting element 700. It is preferable to form as shallow as possible an indented region 250, in that, as previously described with reference to figures 6 and 7b, the depth of indented region 250 is approximately equal to the height of the embossed portion formed by outer face 200of of back-contact back-sheet 200 in correspondence to indented region 250. While assembling the photovoltaic module, it is an advantage if back-contact back-sheet 200 has as planar as possible an outer face 200of. For example, outer face 200of of back-contact back-sheet 200 may be laid on the surface of a vacuum table, which requires outer face 200of to be flat in order to obtain the desired effect of fixing the back-contact back-sheet to the table. It is therefore desirable that the protrusion on outer face 200of in correspondence to indented region 250 has as reduced a height as possible. Therefore, depth H may advantageously be limited within the range of approximately 100 µm to approximately 500 µm and, even more advantageously, of approximately 100 µm to approximately 300 µm.

With reference to figure 10b and in view of the above discussion, one can furthermore notice that depth H of cavity 251 sets an upper bound to thickness 720t of contact portion 720 of connecting element 700. In particular, it is advantageous to use connecting elements 700 comprising a contact portion 720 with a thickness 700t which is slightly less or approximately equal to depth H of cavity 251. Thickness 720t of contact portion 720 may however not be reduced at will, since connecting element 700 with too thin contact portions 720 might likely be damaged during the manufacturing stages or the normal operation of the photovoltaic module. For instance, if the ratio of the thickness of contact portion 720 to the thickness of transport portion 740 was too small, then it would turn out to be difficult to manipulate connecting element 700. An excessive difference between the thicknesses of contact portion 720 and transport portion 740 might in extreme cases result in a complete detachment of contact portion 720 from transport 740, thereby rendering connecting element 700 useless. A too thin contact portion 720 might then not effectively conduct the electrical current. In general, it is thus not advisable to use connecting elements with a thickness less than approximately 100µm.

Due to the above, it is advantageous to choose a value of depth H of cavity 251 which is a reasonable compromise between the need to reduce depth H of indented region 250 as much as possible and the necessity of using connecting element 700 whose contact portion 720 has a thickness which is not less than a minimum allowed value.

Figure 10b also shows that the size dimensions of through hole 256 are chosen in relation to the dimensions of the cross section of the subportion of transport portion 740 housed in hole 256. In particular, figure 10b shows that width 256w, i.e., the dimension along the horizontal x-axis, of hole 256 is approximately equal to or slightly greater than thickness 740t of transport portion 740 of connecting element 700. For example if thickness 740t of transportation portion 740 is of about 600 µm, width 256w of hole 256 may be advantageously in the range of approximately 600 µm to approximately 1000 µm. Thickness 740t of transport portion 740 may be approximately equal to thickness 720t of contact portion 720 of connecting element 700.

Analogously, figure 10a shows that length 256l, i.e., the dimension along the horizontal y-axis, of hole 256 shown in figure 7a, is chosen so as to be approximately equal to or slightly greater than width 740w of transportation portion 740 indicated in figure 9a. Width 740w of transport portion 740 may for example vary in the range of about 1 mm to about 10 mm. Consequently, length 256l of hole 256 may advantageously vary in the range of about 1 mm to about 15 mm.

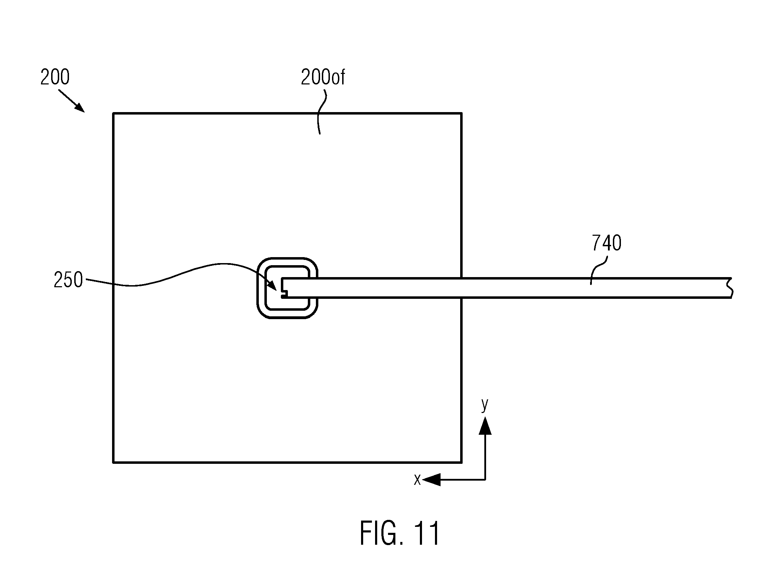

As shown in figure 11, after introducing connecting element 700 through the thickness of back-contact back-sheet 200 and fixing this to the inner face 200if as shown above, transport portion 740 of connecting element 700 may be further bent so as to cause transport portion 740 to lie on a plane substantially parallel to the plane upon which back-contact back-sheet 200 lies. Bending is carried out, as described above, by means of a rotation of transport portion 740 with respect to contact portion 720 by a suitable angle. With reference to figures 10b and 11, transport element 740 is rotated about an axis substantially parallel to the y-axis and by an angle approximately equal or slightly less than 90° in order to bring the system from the configuration shown in figure 10b to that shown in figure 11.

Figure 11 shows an advantageous final configuration of the system including back-contact back-sheet 200 according to the present invention and a connecting element 700 coupled thereto. This configuration may be advantageous in view of the use of back-contact back-sheet 200 in a photovoltaic module included in a photovoltaic plant or an array of modules using a junction box in order to collect and process the signal coming from the photovoltaic modules.

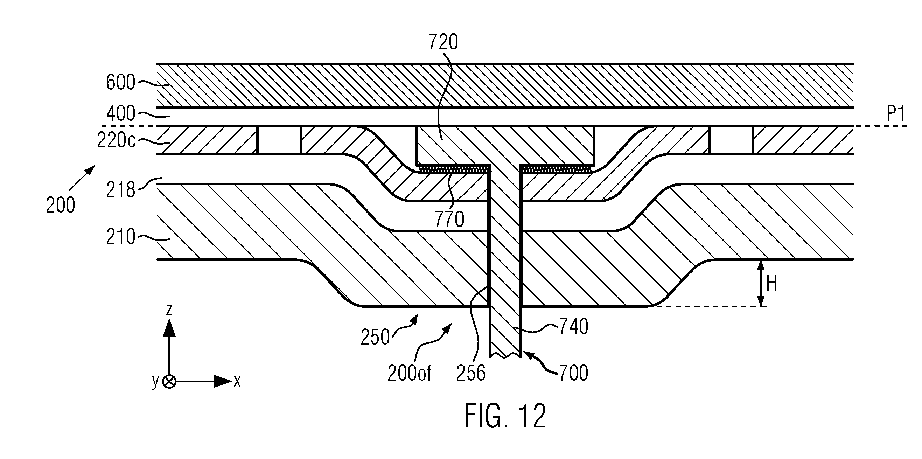

Figure 12 shows how back-contact back-sheet 200 and a connecting element 700 cooperating therewith may be used in a photovoltaic module. Figure 12 shows a back-contact back-sheet 200 comprising a substrate 210, a primer layer 218 and a connecting circuit 220c attached to primer layer 218. An indented region 250 has been previously formed in a predetermined area of back-contact back-sheet 200. Indented region 250 comprises through hole 256 preferably formed in a central area of indented region 250. The connecting element 700 has been inserted into back-contact back-sheet 200 so that its transport portion 740 is partially housed in hole 256, as described above. Furthermore, contact portion 720 of connecting element 700 has been attached to upper surface 226 of conductive layer 220c again in one of the manners described above.

Figure 12 shows a state in the manufacturing of the photovoltaic module wherein lower encapsulating layer 400 has been applied to inner face 200if of back-contact back-sheet 200 and a photovoltaic cell 600 has been placed onto lower encapsulating layer 400. Since the surfaces of contact portion 720 and of connecting circuit 220c exposed towards the inside of the photovoltaic module are substantially on the same plane P1, lower encapsulating layer 400 and cell 600 lie on a substantially planar and flat surface. Analogously, all other components of the photovoltaic module arranged over cell 600 and not shown in figure 12 will be supported by a flat, non-bent surface.

It should be noted that the back-contact back-sheet lies at the bottom of the stack of components shown in figures 1, 2a and 2b. In order for all components of the photovoltaic module to be effectively stacked and assembled by means of the lamination process, it is crucial that back-contact back-sheet 200 be as planar as possible. In particular, it is crucial that inner face 200if of back-contact back-sheet 200 facing the inside of the photovoltaic module be substantially flat. Possible curvatures of the back-contact back-sheet and, in particular, of its inner face 200if would jeopardize the stability of the stack of elements (lower encapsulating material layer 400, cell 600, upper encapsulating material layer 450, upper protective layer 800) formed thereupon. Furthermore, if back-contact back-sheet 200 is curved, tensions may likely arise across the surface and within cells 600 or within upper protective layer 800 which, in general, are not flexible.

The present invention provides a back-contact back-sheet which, when cooperating with one or more suitable connecting elements, offers a substantially flat surface towards the inside of the photovoltaic module. In this manner, the components of the photovoltaic module may be assembled on a flat support, thus preventing tensions from arising in stiff module components.

The present invention cleverly solves the problem of the electrical contact between the connecting circuit of the back-contact back-sheet and the connecting elements or busbars which are responsible for the exchange of the electrical current between the photovoltaic module and the rest of the photovoltaic plant. The back-contact back-sheet is provided with one or more regions indented towards the air-side of the photovoltaic module. These regions comprise a through hole which brings a connecting circuit into communication with the external face of the back-contact back-sheet. Each indented region is adapted to house a respective connecting element which comprises a contact portion fixed to the connecting circuit and a transport portion adapted to bring the signal coming from the photovoltaic cells from the connecting circuit to the outside of the photovoltaic module or vice versa. In particular, the part of the transport portion of the connecting element is adapted to lie outside of the photovoltaic module and to be electrically connected to an appropriate control unit or a junction box of the photovoltaic plant.

The connecting element can be easily induced to cooperate with the back-contact back-sheet, since it is sufficient to introduce its transport portion into the through hole of a predetermined indented region.

The contact portion of that connecting element is then attached to a portion of the connecting circuit included in the indented region wherein the through hole partially housing the transport portion is formed. Since the side dimensions and depth of the indented region are chosen based on the side dimension and depth of the contact portion, the contact portion is entirely included in the cavity defined by the indented region when this is fixed to the connecting circuit. Since the contact portion of each connecting element is housed within the cavity formed by a respective indented region, the system comprising the back-contact back-sheet and the connecting elements exposes towards the outside of the photovoltaic module a substantially flat, planar and smooth face. This provides a reliable support upon which the constituent parts of the photovoltaic module may be assembled or stacked.

Furthermore, according to the present invention the contact portion of the connecting element is attached to the upper surface of the connecting circuit, i.e., to the surface of the connecting circuit exposed towards the inside of the photovoltaic module. Conversely, in the state of the art the connecting element is attached to the surface of the connecting circuit exposed towards the substrate of the back-contact back-sheet, as shown for example in figure 3. Thus, a portion of the lower surface of the connecting circuit must have been previously exposed through windows formed in the insulating substrate, which increases the risks of damage or erosion of the circuit as shown above. Furthermore, the lower surface of the circuit might be oxidized or be damaged due to the process of forming the windows in the insulating substrate, thus reducing its electrical conductivity. The connecting element must thus be first inserted into one of the windows exposing the surface of the connecting circuit circuit exposed toward the substrate and must subsequently be welded to the exposed portion of the surface of the connecting circuit.

According to the present invention the connecting element is instead fixed to the upper surface of the connecting circuit adapted to be exposed towards the inside of the photovoltaic module. The surface may have been previously treated in order to increase its conductivity and improve the electrical contact with the photovoltaic cells. For example, a treatment may have been performed on the upper surface aimed at removing the surface oxide film and forming a conductive protection layer comprising a metal having a high conductivity and substantially stainless. In particular, if the circuit comprises aluminum, the surface of the aluminum layer to be exposed may have been treated so as to deposit a thin silver film thereupon or a film of a different noble metal.

Hence, the electrical connection between the connecting element and the upper surface of the circuit may be established in a simply and reliable manner, due to the advantages resulting from the surface treatment previously carried out. For example, in the case of a circuit comprising aluminum, the connecting element may be simply and effectively fixed to the surface of aluminum plated with the thin metal film of silver, gold or copper by means of welding or an electrically conductive adhesive. The reliability of the electrical contact between a connecting element and the circuit is thus guaranteed by a surface treatment. Since the surface of the connecting element to be fixed to the connecting circuit may advantageously comprise copper or a noble metal, lengthy techniques such as spot welding or ultrasonic welding do not have to be used, which would instead be required for joining two components exposing aluminum surfaces. Furthermore, one does not have to treat the lower surface of the connecting circuit, i.e., the surface facing the insulating substrate, in order to improve its electrical conductivity.

The present invention further eliminates a need for windows 215 through the insulating substrate 210 according to the state of the art and shown in figure 3. The present invention proposes to replace the windows in the substrate with a through hole associated with a connecting element. Forming a through hole extending throughout the connecting circuit and the substrate is much easier than forming a window having a predetermined length exactly equal to the thickness of the substrate. In particular, no undesired erosion of connecting circuit 220c may arise when forming the through holes, nor can undesired residual portions of insulating material remain on the surface of connecting circuit 220c to be contacted by the connecting element.

Furthermore, according to the present invention, when connecting element 700 is inserted into hole 256 of the back-contact back-sheet and attached to the connecting circuit 220c in operating position, the contact portion 720 of the connecting element 700 faces the face of the back-contact back-sheet opposite the face faced by the free subportion of transport portion 740 not housed in hole 256. Therefore, the electrical contact between connecting element 700 and back-contact back-sheet 200 according to the present can withstand tensile stresses to a much greater extent than the surface contact shown in figure 3 between a busbar and a back-contact back-sheet known from the state of the art. Tensile stresses applied to the connecting element are frequent when inserting the free subportion of transport portion 740 of connecting element 700 into a junction box.

It should also be noted that the present invention allows one to use connecting elements having several shapes and dimensions. In particular, one can choose the thickness of the connecting element at will. Yet more specifically, thickness 720t of contact portions 720 may be chosen within a wide range. After choosing the thickness 720t of contact portion 720, indented regions 250 may be formed defining each a respective concavity having a predetermined depth H matching the thickness 720t of contact portion 720. Furthermore, the width 256w of through hole 256 can be adjusted depending on thickness 740t of transport portion 740 of connecting element 700.

In figures 6, 7b, 10b and 12, embodiments of the invention are represented wherein both inner face 200if and outer face 200of of the back-contact back-sheet comprise a curved portion in correspondence with an indented region 250. In other words, in the embodiments represented in the figures, the indented region 250 extends through the entire thickness of back-contact back-sheet 200.

It should be observed that according to these embodiments, the protrusion or convexity formed by outer face 200of of back-contact back-sheet 200 in correspondence to an indented region has typically a height of a few hundred micrometers, which is a much smaller order of magnitude than the typical size dimensions of a back-contact back-sheet (approximately 1 meter x 1.7 meters). Therefore, from a macroscopic point of view, the protrusion on outer face 200of of the back-contact back-sheet is barely perceptible. In this manner, outer face 200of may be considered to be almost flat, even after indented regions 250 have been formed. In this regard, it should also be observed that the height of a protrusion formed by outer face 200of of the back-contact back-sheet in correspondence to indenter region 250 may advantageously be reduced down to an allowed minimum limit by reducing the depth H of cavity 251 formed by indented region 250.

According to other embodiments of the invention not shown in the figures, the indented portion 250 of the back-contact back-sheet 200 is only formed in correspondence to inner face 200if of the back-contact back-sheet and not on outer face 200of. Hence, inner face 200if forms a concavity facing upwards in correspondence to indented region 250, whereas outer face 200of remains substantially flat. According to this embodiment, the depth H of the concavity formed by the indented region 250 is less than the thickness of back-contact back-sheet 200.

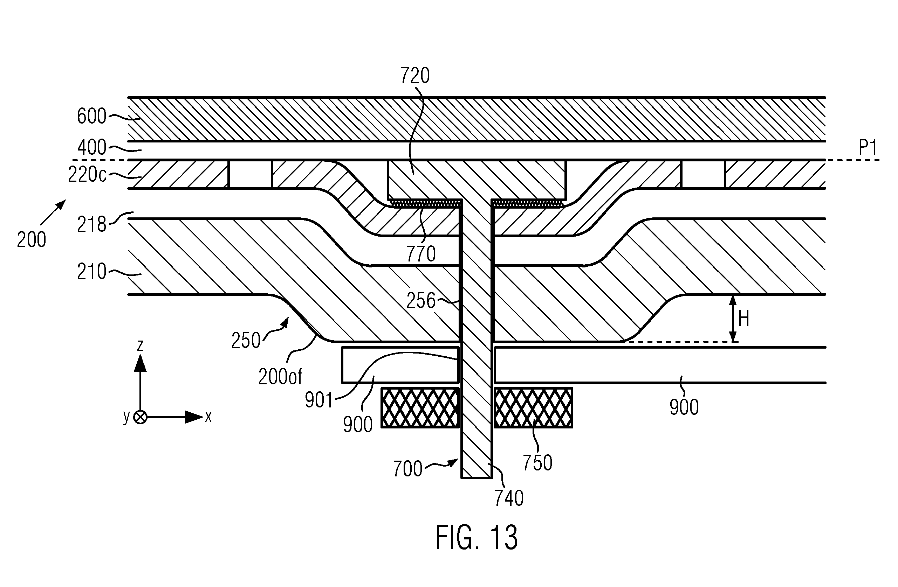

Figure 13 shows a cross-sectional view of a portion of a photovoltaic module including a back-contact back-sheet 200 and an external connecting element 900 according to a further embodiment of the present invention.

The external connecting element 900 is placed outside with respect to back-contact back-sheet, for example underneath the back-contact back-sheet, in contact with the outer side of the back-contact back-sheet and may for example be adapted to connect the system with a junction box.

The connecting element 700 is in electrical contact with the external connecting element 900 so as to allow electrical contact between the circuit 220c and the external connecting element 900. In particular, the transport portion 740 of the connecting element 700 goes through the hole 901 of the external connecting element 900. Moreover, the transport portion 740 is safely kept in its position by means of locking element 750. In particular, locking element 750 guarantees stability of the system by locking the connecting element 700 in the position shown in the figure, thus keeping the external connecting element 900 firmly fastened to the back-contact back-sheet 200.

The locking element 750 may comprise any kind of element known to the skilled person. For example, locking element 750 may be part of the connecting element 700 and may thus comprise for example an enlargement of the transport portion 740 of the connecting element 700, for example an enlargement of the stem of a rivet. Alternatively, the locking element may consist of a further element which is independent from the connecting element 700.

The docking element 750 is particularly advantageous because it allows the replacement of the fixing means 770 with an element which optimizes the electrical conductivity between the contact portion 720 of the connecting element 700 and the connecting circuit 220c but which does not necessarily guarantees the structural fixing, since this functionality is guaranteed by the locking element 750. In particular, whereas in some embodiments of the present invention the fixing means 770 comprises an electrically conductive adhesive, such as ECA, which optimizes the conduction and, at the same time, guarantees the fixing of the connecting element 700 to the system, in the embodiments wherein a locking element 750 is provided, it is possible to employ a conductive ring, made for example of copper or of aluminium or of a conductive elastomer, or a conductive paste, for example a carbon paste or a copper paste, instead of the fixing means 770. This allows avoiding the need of the polymerization of the electrically conductive adhesive, thus reducing production costs and time. In particular, electrically conductive adhesives must be polymerized with a procedure of about 15 minutes at a temperature comprised between 145°C and 160°C so as to guarantee the fixing functionality. On the contrary, when the system comprises a locking element 750, such as for example, the one schematically shown in Figure 13, it is possible to employ a conductive paste without polymerization or a ring made of conductive metallic or elastomeric material with the aim of improving electrical conductivity between the element 720 and the circuit 220c but without fixing functionality.

The external connecting element 900 may comprise one or more holes 901 for housing the transport portion 740 of the connecting element 700. The external connecting element 900 may be punched in advance, so as to exhibit one or more holes 901 prior to the assembly in the system as shown in Figure 13. It is thus necessary to align the holes 901 of the external connecting element 900 with the through holes 256 of the back-contact back-sheet prior to the insertion of the connecting element 700.

Alternatively, holes 901 may be made by means of the connecting element 700 itself. In particular, transport portion 740 of the connecting element 700 may be adapted to punch the external connecting element 900. For example, if the connecting element 700 comprises a rivet, the stem of the rivet may advantageously be pointed so as to punch the external connecting element 900. This embodiment is particularly advantageous because it is no longer necessary to align the holes of the external connecting element 900 to the through holes 256 of the back-contact back-sheet. In particular, the external connecting element 900 is placed underneath the back-contact back-sheet 200 and when the transport portion 740 of the connecting element 700 is inserted into the through hole 256, the external connecting element 900 is punched as well, thus forming the hole 901.

The present invention also proposes a method of manufacturing a back-contact back-sheet according to the embodiments discussed above.

During the first stage of the method according to the present invention, an insulating substrate 210 is provided in one of the forms described above with reference to Figures 4 and 5.

We now refer back to Figures 4 and 5. After implementing substrate 210, an electrically conductive material layer 220 is applied to inner surface 210is of substrate 210 opposite outer surface 210of exposed towards the air-side. Conductive material layer 220 is applied so as to be firmly fixed to inner surface 210is of insulating substrate 210. The lower surface of conductive material layer 220 is fixed to inner surface 210is of substrate 210. The upper surface of conductive material layer 220 remains instead exposed so as to be included in inner face 200if of back-contact back-sheet 200.

A treatment may be applied to the upper surface of conductive material layer 220 in order to remove the layer of native oxide therefrom, thereby increasing the electrical conductivity. For example, after removing the oxide, a conductive protective layer may be deposited on the upper surface comprising a metal having a high conductivity and much less prone to oxidation than the metal constituting electrically conductive material 220. For example, a treatment aimed at removing the layer of native oxide may be applied to the upper surface followed by a deposition, preferably performed in a vacuum, of a thin protective metal layer. The treatment consisting of an oxide removal followed by deposition of the thin film may be advantageously performed onto conductive material layer 220 before this is coupled with substrate 210. This treatment has been described in Italian Patent Application Nr. VI2012A000266.

The treatment aimed at removing the oxide may comprise a wet or dry chemical etch. For example, a plasma may be used in order to remove the oxide layer from the upper surface of the electrically conductive layer. Advantageously, a hydrogen plasma may be used.

The deposition of the thin protective layer can be advantageously carried out by means of a chemical vapor deposition. Alternatively, well-established thin film deposition techniques may be used such as, for example, chemical vapor deposition, plasma enhanced chemical vapor deposition, metal organic chemical vapor deposition, molecular beam epitaxy, etc. If the conductive material layer comprises aluminum, the protective layer preferably comprises silver or a metal alloy comprising silver. Together with or in alternative to silver, other metals may be deposited such as nickel, tin, tantalum, cobalt or even copper, or aluminum-copper alloys. Silver is an advantageous choice due to its high electrical conductivity. As a noble metal, silver is then particularly stable in air, since an exposed silver surface barely reacts with those gases (oxygen, water vapor, nitrogen, carbon dioxide, etc.) normally present in air at standard pressure. Furthermore, silver is compatible with the electrically conductive adhesives (such as ECA) which are typically silver based.

Electrically conductive material layer 220 may be attached to inner surface 210is of substrate 210 by means of adhesives. If inner surface 210is of substrate 210 comprises a thermal adhesive material, such as for example in one of the embodiments described with reference to figure 5, then electrically conductive material layer 220 may be applied to inner surface 210is and attached thereto by simply heating the system so as to activate the adhesive function of the thermal adhesive material. For example, the system may be heated at a temperature in the range of 80°C to 140°C in order to fix layer 220 to inner face 210is of substrate 210 comprising a thermal adhesive material.

Still with reference to Figures 4 and 5, conductive material layer 220, when being applied to inner surface 210is of substrate 210, is usually in the form of a full and continuous foil and its surface does not have any channels, indentations or meanders. In this case, conductive material layer 220 is subsequently processed so as to form a pattern comprising for example elongated elements such as tracks, paths, etc., separated by channels 224. As described above, these pattern forms connecting circuit 220c connecting back-contact back-sheet 200 with the electrodes of the solar cells. Processing of conductive material layer 220 in order to define connecting circuit 220c may be achieved, for example, by means of optical lithography or, preferably, by means of mechanical milling.

Alternatively, conductive material layer 220 is provided as a pre-printed foil wherein connecting circuit 220c has been previously formed. The foil printed in the form of a circuit is then attached to the inner surface 210is of insulating substrate 210 of the back-contact back-sheet 200.

On the upper surface 226 of connecting circuit 220c a thin layer of an organic material (organic solderability preservative, OSP) may be formed. An OSP layer may be formed, for example, by means of screen printing. OSP layers are particularly advantageous in the case of a connecting circuit comprising copper.

According to the method according to the present invention, after applying conductive layer 220 to substrate 210, one or more indented regions 250 are formed in predetermined areas of back-contact back-sheet 200, as shown in figure 6. With reference to Figure 6, these indented regions 250 are formed with the features described above. In particular, each indented region 250 is formed so as to include a portion of connecting circuit 220c and in such a way that upper surface 226 of connecting circuit 220c forms a concavity facing the inside of the photovoltaic module in correspondence to the indented region 250 being considered. The size dimensions of each indented region 250 and the depth H of the concavity thereby defined are chosen based on the particular connecting element to be used, as described above.

In order to form an indented region 250, a plastic deformation of a predetermined area of the back-contact back-sheet 200 may be performed by using a well-established technique. For example, according to an embodiment of the invention, the deformation is performed by using a press comprising a pressing element and a matrix containing a housing for each pressing element. The pressing element comprises a protruding portion having the same shape, size dimensions and height of the indented region 250 to be formed. In particular, the protrusion of the pressing element comprises a flat portion extending on a horizontal plane adapted to form flat portion 252 of indented region 250 shown in figure 6. Back-contact back-sheet 200 to be deformed is arranged between the pressing element and the matrix. The pressing element is then pushed towards the matrix so that the back-contact back-sheet is compressed between the pressing element and the matrix. The pressure thereby exerted results in the plastic deformation which, in turn, forms indented region 250.

The plastic deformation of back-contact back-sheet 200 is thus a rather easy task to be accomplished, since well-established techniques are available.

The plastic deformation of back-contact back-sheet 200 in order to form indented regions 250 may be performed either before or after processing conductive layers 220 in order to form connecting circuit 220c. Advantageously, the plastic deformation may be carried out after connecting circuit 220c has been formed in conductive material layer 220. In this manner, the area or the predetermined position of back-contact back-sheet 200 in which indented region 250 is to be formed can be more easily identified. As noted above, it is crucial that indented region 250 includes a portion of connecting circuit connecting circuit 220c. Hence, determining where an indented region is to be formed is easier after connecting circuit 220c has been formed.

According to the method according to the present invention, back-contact back-sheet 200 is pierced in order to form therein one or more through holes extending from upper surface 226 of connecting circuit 220c to lower face 200of of the back-contact back-sheet. Each through holes 256 is formed within a respect indented region 250. Preferably, a through hole 256 is formed in the central flat portion 252 of a respective indented region 250. Preferably, only one through hole 256 is formed in one indented region 250.

Through holes 256 may be formed by using well-established mechanical techniques such as for example punching or milling. The task of forming through holes 256 is thus also relatively easy, since well-established techniques are available in the state of the art for this kind of task.

The operation of forming holes 256 may be carried out both before and after performing the plastic deformation in order to form one or more indented regions 250. Furthermore, holes 256 may be formed either before or after processing conductive layer 220 in order to form the connecting circuit 220c. Advantageously, holes 256 may be formed after connecting circuit 220c has been formed. In this case, analogously to the discussion provided above in regard to formation of indented region 250, forming holes 256 in pre-determined position of the back-contact back-sheet is easier if a connecting circuit has been previously formed which can be used as a position reference.

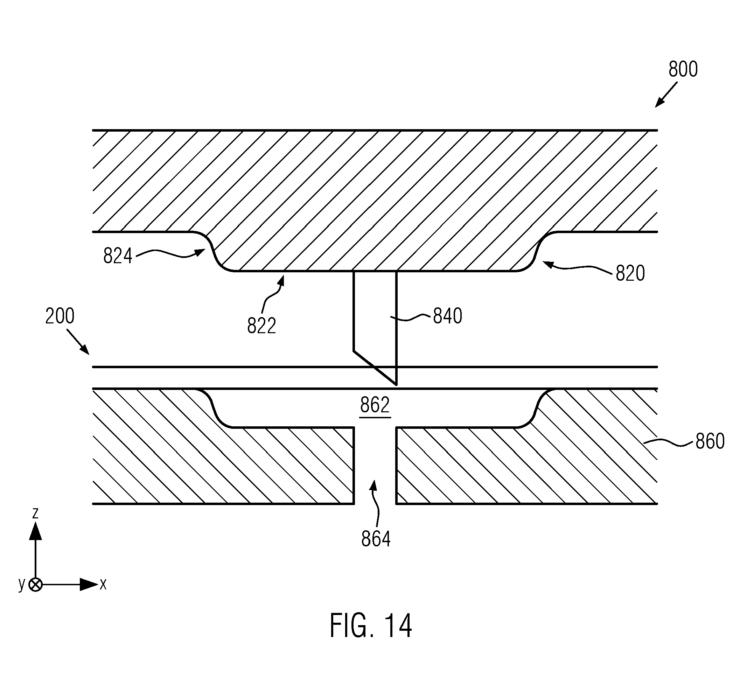

According to an advantageous embodiment of the present invention, through holes 256 are formed during the same operation permitting formation of the respective indented regions 250. According to this embodiment, an apparatus such as that schematically shown in Figure 14 may be used. With reference to Figure 14, the pressing element 800 comprises a protruding element 820. Protruding element 820 includes a substantially flat area 822 which exposes a surface lying on a substantially horizontal plane. Flat area 822 is surrounded by a connecting area 824 connecting flat area 822 to the main body of pressing element 800. A punch 840 extending along a substantially vertical direction protrudes from the centre of flat area 822. Protruding element 820 and punch 840 face a matrix 860 which comprises a first housing 862 adapted to house protruding element 820 of pressing element 800. Matrix 860 further comprises a second housing 864, communicating with first housing 862 and adapted to house punch 840.

The back-contact back-sheet 200 to be pierced and deformed in a plastic manner is laid on the surface of matrix 860 facing pressing element 800. When pressing element 800 is pushed towards matrix 860, punch 840 initially abuts onto back-contact back-sheet 200 and subsequently pierces back-contact back-sheet 200, thereby forming a through hole 256 shown in Figure 6.

Again with reference to Figure 14, after forming the through-hole and as the distance between pressing element 800 and the matrix 860 decreases, punch 840 enters housing 862 and slides therein. In the meantime, the back-contact back-sheet 200 is pushed inside housing 862 and is compressed between protruding element 820 and the surface of matrix 860 defining housing 862. The pressure exerted on back-contact back-sheet 200 results in a plastic deformation which, in turn, produces an indented region 250. In particular, flat portion 252 of the indented region shown in Figure 6 is formed due to the pressure exerted by flat area 822 of protruding element 820 shown in Figure 14. On the other hand, curved portion 254 of indented region 250 shown in Figure 6 is formed due to the pressure exerted by connecting area 824 of protruding element 820 shown in Figure 14.

In this manner, hole 256 and respective indented regions 250 may be formed by means of a single process stage. Furthermore, by using the apparatus shown in Figure 14, the position of a hole 256 with respect to the corresponding indented region 250 may be finely adjusted.

Hence, the method according to the present invention allows one to form indented regions 250 and through holes 256 in a back-contact back-sheet inside which the appropriate connecting elements may be housed. In this manner, the electrical signal collected from the electrodes of the photovoltaic cells may be easily transferred outside of the photovoltaic module through the connecting circuit connecting circuit 220c. Through holes 256 as well as indented regions 250 are easily, quickly and cost effectively formed. The need can thus be avoided for forming windows through substrate 210 which expose towards the outside the lower surface of connecting circuit 220c.

After connecting circuit 220c, indented regions 250 and through holes 256 have been formed in the back-contact back-sheet, one or more connecting elements 700 may be coupled with and attached to the back-contact back-sheet 200, as described above with reference to Figure 10b. Preferably, an indented region 250 houses at most a respective connecting element. In particular, the transport portion 740 of a connecting element 700 is inserted into a respective through hole 256 until the contact portion 720 of the connecting element electrically contacts connecting circuit 220c.

Connecting element 700 is then fixed to the inside of the indented region 250 wherein through hole 256 is formed, so that its contact portion 720 is housed in the cavity 251 formed by connecting circuit 220c in correspondence to indented region 250. In particular, connecting element 700 is fixed to the exposed upper surface 226 of connecting circuit 220c so that the exposed surface 722 of its contact portion 720 is substantially coplanar with the portion of upper surface 226 of connecting circuit connecting circuit 220c not included in any indented regions 250. Thus, the face of the back-contact back-sheet facing the inside of the photovoltaic module is substantially flat after connecting elements 700 have been fixed to connecting circuit 220c.

Contact portion 720 of connecting element 700 may be easily fixed to upper surface 226 of connecting circuit 220c in the manner described above. In particular, the fixing operation is easier with respect to the state of the art in that it is carried out on the upper surface of the connecting circuit and not on its lower surface, as the method known from the state of the art requires. This enables an easier, more reliable and more effective connection of the connecting element to the connecting circuit.

After inserting a connecting element 700 into through hole 256 and after fixing the connecting element to the portion of connecting circuit 220c included in the indented region 250 in which hole 256 lies, transport portion 740 of connecting element 700 may be bent with respect to contact portion 720 so that the plain defined by transport portion 740 is parallel to the plain defined by those portions of outer face 200of of back-contact back-sheet 200 not included in any indented regions 250.

Advantageously, transport portion 740 is bent so as to adhere to outer face 200of of back-contact back-sheet 200. The system thus takes the final configuration shown in Figure 11.

This operation of bending transport portion 740 is preferably performed before laminating the photovoltaic module.

After all connecting elements 700 have been coupled to back-contact back-sheet 200 and fixed to connecting circuit connecting circuit 220c, the process of manufacturing the photovoltaic module continues as described with reference to Figures 1, 2a and 2b.

Again with reference to Figures 1, 2a and 2b, a lower encapsulating material layer 400, appropriately pierced, is aligned and applied to inner face 200if of back-contact back-sheet 200, i.e. to the face comprising connecting circuit connecting circuit 220c. Lower encapsulating material layer 400 may be replaced by a multilayered structure, also appropriately pierced, described in Italian patent application numbers VI2012A000133 and VI2012A000169.

After depositing a lump of conductive paste 300 onto each contact pad 222 of connecting circuit 220c, photovoltaic cells 600 are laid onto lower encapsulating material layer 400 or onto the multilayered structure which have been previously pierced. Cells are arranged onto lower encapsulating material layer 400 or the multilayered structure so that their electrodes 620 and 640 are electrically connected to contact pads 222 of connecting circuit 220c by means of the lumps of conductive paste 300.
Upper encapsulating material layer 450, arranged on the cells and upper protective layer 800, arranged on upper encapsulating material layer 450, then complete the stack. The stack thus formed is then laminated as described above so as to obtain the assembled photovoltaic module.

Although the present invention has been described with reference to the embodiment described above, it is clear for a skilled person that it is possible to design several modifications, variations and improvements of the present invention in view of the teachings described above and within the scope of the attached claims without departing from the object and the scope of protection of the invention. Furthermore, those aspects deemed to be known by a skilled person have not been described in order to unduly obfuscate the described invention. Consequently, the invention is not restricted to the embodiments described above and is exclusively limited by the scope of protection of the attached claims.

## Claims

1. Back-contact back-sheet (200) for a photovoltaic module comprising back-contact solar cells, said back-contact back-sheet (200) comprising an outer face (200of) facing the air-side of a respective photovoltaic module and an inner face (200if) opposite said outer face and exposed towards the inside of said respective photovoltaic module, said back-contact back-sheet (200) comprising:
a substrate (210) having an outer surface (210os) substantially coincident with said outer face (200of) of said back-contact back-sheet (200) and an inner surface (210is) opposite said outer surface (210os) and exposed towards the inside of said photovoltaic module,
a layer of an electrically conductive material (220) adapted to be formed as a connecting circuit (220c) to the electrodes of said solar cells, said layer of electrically conductive material (220) comprising a lower surface facing said inner surface (210is) of said substrate (210) and an upper surface opposite said lower surface,
one or more through-holes (256) such as to bring into communication said upper surface of said conductive layer (220) with said outer face (200of) of said back-contact back-sheet (200),
wherein at least one of said through-holes (256) lies within an indented region (250) of said back-contact back-sheet (200) and wherein said indented region (250) comprises a portion of said connecting circuit (220c) so that said portion of said connecting circuit (220c) defines a cavity (251) facing the inside of said photovoltaic module.

2. Back contact back sheet according to claim 1, wherein said substrate (210) of said back-contact back-sheet (200) comprises:
a first insulating layer (212) of a first polymeric material having an outer surface facing said air-side of said photovoltaic module and an inner surface opposite said outer surface,
a second insulating layer (216) of a second polymeric material coupled to said inner surface of said first insulating layer (212).

3. Back-contact back-sheet according to one of the claims 1 or 2, wherein said substrate (210) comprises:
an insulating portion (211) comprising a lower surface facing the air-side of said photovoltaic module and substantially coincident with said outer surface (210os) of said substrate (210) and an upper surface opposite said lower surface,
a primer layer (218) firmly fixed to said upper surface of said insulating portion (211), said primer layer (218) comprising a lower surface facing said upper surface of said insulating portion (211) and an upper surface opposite said lower surface of said primer layer (218) and substantially coincident with said inner surface (210is) of said substrate (210).

4. Back-contact back-sheet according to one of the claims from 1 to 3 wherein said layer of electrically conductive material (220) comprises copper, aluminium, or an alloy of copper and aluminium.

5. Back-contact back-sheet according to one of the claims from 1 to 4 wherein the portion of said inner face (200if) of said back-contact back-sheet (200) included in said indented region (250) is exclusively comprised of a portion of said connecting circuit (220c).

6. Back-contact back-sheet according to one of the claims from 1 to 5 wherein said indented region (250) comprises a substantially flat portion (252) so that the portion of said inner face (200if) of said back-contact back-sheet (200) included in said substantially flat portion (252) lies on a plane (P2) substantially parallel and placed at a predetermined distance (H) with respect to the plane (P1) defined by the portions of said inner face (200if) of said back-contact back-sheet (200) not belonging to any indented regions (250).

7. A photovoltaic module comprising:
a back-contact back-sheet according to one of the claims from 1 to 6,
at least one connecting element (700) comprising a contact portion (720) and a transport portion (740), said contact portion (720) being fixed to a portion of said upper surface of said layer of electrically conductive material (220) included in said indented region (250) and electrically connected with said layer of conductive material (220), said transport portion (740) being at least partially housed in the through-hole (256) lying in said indented region (250).

8. A photovoltaic module according to claim 7, wherein said connecting element (700) comprises a rivet comprising a head and a stem, said head extending across a plane substantially parallel to the plane onto which said inner face (200if) of said back-contact back-sheet (200) lies, said contact portion (720) of said connecting element (700) comprising said head of said rivet, said transport portion (740) of said connecting element comprising said stem of said rivet.

9. A photovoltaic module according to one of claims 7 or 8, further comprising an external connecting element (900) in electrical contact with said connecting element (700), wherein said connecting element (700) and said external connecting element (900) are fastened to each other by means of a locking element (750).

10. A photovoltaic module according to one of claims 7 to 9, wherein said contact portion (220) is electrically connected with said layer of conductive material (220) by means of fixing means (770), for example an electrically conductive adhesive, or by means of a conductive paste, for example a carbon paste or a copper paste, or by means of a ring made of conductive metallic or elastomeric material, for example a copper ring or an aluminium ring or a ring made of a conductive elastomer.

11. Method of producing a back-contact back-sheet (200) for a photovoltaic module comprising back-contact solar cells, said back-contact back-sheet (200) comprising an outer face (200of) facing the air-side of said photovoltaic module, and an inner face (200if) opposite said outer face (200of) and exposed towards the inside of said photovoltaic module, said method comprising:
providing a substrate (210) having an outer surface (210os) coincident with said outer face (200of) of said back-contact back-sheet (200) and an inner surface (210is) opposite said outer surface (210os) and exposed towards the inside of said photovoltaic module,
applying to said substrate (210) a layer of an electrically conductive material (210) comprising a lower surface and upper surface opposite said lower surface, said layer of electrically conductive material (220) being applied to said substrate so that said lower surface of said layer of conductive material (220) is fixed to said inner surface (210is) of said substrate (210) and that said inner face (200if) of said back contact back sheet comprises said upper surface of said layer of conductive material (220),
processing said layer of electrically conductive material (220) in order to form a connecting circuit (220c) for connection to the electrodes to said solar cells,
performing a plastic deformation of at least one region of said back-contact back-sheet (200) containing a portion of said connecting circuit (220c), said plastic deformation being performed so as to form an indented region (250) which is indented towards said air-side of said photovoltaic module so that said portion of said connecting circuit (220c) contained in said indented region (250) defines a cavity facing the inside of said photovoltaic module,
piercing said back contact back sheet (200) so as form at least one through-hole (256) such as to put into communication said upper surface of said layer of electrically conductive material (220) with said outer face (200of) of said back-contact back-sheet (200), said through-hole (256) being contained in said indented region (250) of said back contact back sheet (200).

12. Method according to claim 11, wherein said plastic deformation is performed after said step of applying said layer of electrically conductive material (220) to said substrate (210).

13. Method according to one of the claims 11 or 12, wherein said step of piercing said back-contact back-sheet (200) is performed by means of through-punching.

14. Method for producing a photovoltaic module comprising:
producing a back-contact back-sheet (200) according to the method of one of the claims from 11 to 13;
coupling at least one connecting element (700) to said back-contact back-sheet (200), said connecting element (700) comprising a contact portion (720) and a transport portion (740), said coupling step comprising:
inserting at least a portion of said transport portion (740) into said through-hole (256),
fixing said contact portion (720) to said connecting circuit (220c) so that said contact portion (720) electrically contacts said connecting circuit (220c).

15. Method according to claim 14, wherein said connecting circuit (220c) comprises an upper surface (226) included in said upper surface of said layer of electrically conductive material (220) and wherein said contact portion (720) of said connecting element (700) is fixed to said upper surface (226) of said connecting circuit (220c).

16. Method according to one of claims 14 or 15, wherein said connecting element (700) comprises a rivet comprising a head and a stem, said head extending across a plane substantially parallel to the plane onto which said inner face (200if) of said back-contact back-sheet (200) lies, said contact portion (720) of said connecting element (700) comprising said head of said rivet, said connecting portion (740) of said connecting element comprising said stem of said rivet.

## Patentansprüche

1. Rückseitenkontakt-Backsheet (200) für ein Photovoltaikmodul, das Rückseitenkontakt-Solarzellen umfasst, wobei das Rückseitenkontakt-Backsheet (200) eine äußere Fläche (200of), die der Luft-Seite eines entsprechenden Photovoltaikmoduls zugewandt ist, sowie eine innere Fläche (200if) umfasst, die der äußeren Fläche gegenüberliegt und zur Innenseite des entsprechenden Photovoltaikmoduls hin freiliegt, wobei das Rückseitenkontakt-Backsheet (200) umfasst:
ein Substrat (210), das eine äußere Fläche (210os), die im Wesentlichen mit der äußeren Fläche (200of) des Rückseitenkontakt-Backsheets (200) deckungsgleich ist, sowie eine innere Fläche (210is) hat, die der äußeren Fläche (210os) gegenüberliegt und zu der Innenseite des Photovoltaikmoduls hin freiliegt,
eine Schicht aus einem elektrisch leitenden Material (220), die so eingerichtet ist, dass sie als eine Verbindungsschaltung (220c) zu den Elektroden der Solarzellen ausgebildet ist, wobei die Schicht aus elektrisch leitendem Material (220) eine untere Fläche, die der inneren Fläche (210is) des Substrats (210) zugewandt ist, sowie eine obere Fläche umfasst, die der unteren Fläche gegenüberliegt,
ein Durchgangsloch oder mehrere Durchgangslöcher (256), das/die die obere Fläche der leitenden Schicht (220) mit der äußeren Fläche (200of) des Rückseitenkontakt-Backsheets (200) in Verbindung bringt,
wobei wenigstens eines der Durchgangslöcher (256) innerhalb eines vorgesehenen Bereiches (250) des Rückseiten-Backsheets (200) liegt und der vorgesehene Bereich (250) einen Abschnitt der Verbindungsschaltung (220c) umfasst, und dabei der Abschnitt der Verbindungsschaltung (220c) einen Hohlraum (251) bildet, der der Innenseite des Photovoltaikmoduls zugewandt ist.

2. Rückseitenkontakt-Backsheet nach Anspruch 1, wobei das Substrat (210) des Rückseiten-Backsheets (200) umfasst:
eine erste isolierende Schicht (212) aus einem ersten Polymermaterial, die eine äußere Fläche, die der Luft-Seite des Photovoltaikmoduls zugewandt ist, sowie eine innere Fläche hat, die der äußeren Fläche gegenüberliegt,
eine zweite isolierende Schicht (216) aus einem zweiten Polymermaterial, die mit der inneren Fläche der ersten isolierenden Schicht (212) gekoppelt ist.

3. Rückseitenkontakt-Backsheet nach einem der Ansprüche 1 oder 2, wobei das Substrat (210) umfasst:
einen isolierenden Abschnitt (211), der eine untere Fläche, die der Luft-Seite des Photovoltaikmoduls zugewandt ist und im Wesentlichen deckungsgleich mit der äußeren Fläche (210os) des Substrats (210) ist, sowie eine obere Fläche umfasst, die der unteren Fläche gegenüberliegt,
eine Primer-Schicht (218), die fest an der oberen Fläche des isolierenden Abschnitts (211) fixiert ist, wobei die Primer-Schicht (218) eine untere Fläche, die der oberen Fläche des isolierenden Abschnitts (211) zugewandt ist, sowie eine obere Fläche umfasst, die der unteren Fläche der Primer-Schicht (218) gegenüberliegt und im Wesentlichen deckungsgleich mit der inneren Fläche (210is) des Substrats (210) ist.

4. Rückseitenkontakt-Backsheet nach einem der Ansprüche von 1 bis 3, wobei die Schicht aus elektrisch leitendem Material (22) Kupfer, Aluminium oder eine Legierung aus Kupfer und Aluminium umfasst.

5. Rückseitenkontakt-Backsheet nach einem der Ansprüche von 1 bis 4, wobei der Abschnitt der inneren Fläche (200if) des Rückseitenkontakt-Backsheets (200), der in dem vorgesehenen Bereich (250) eingeschlossen ist, ausschließlich aus einem Abschnitt der Verbindungsschaltung (220c) besteht.

6. Rückseitenkontakt-Backsheet nach einem der Ansprüche von 1 bis 5, wobei der vorgesehene Bereich (250) einen im Wesentlichen flachen Abschnitt (252) umfasst und der Abschnitt der inneren Fläche (200if) des Rückseitenkontakt-Backsheets (200), der in dem im Wesentlichen flachen Abschnitt (252) eingeschlossen ist, in einer Ebene (P2) liegt, die im Wesentlichen parallel und in einem vorgegebenen Abstand (H) in Bezug auf die Ebene (P1) positioniert ist, die durch die Abschnitte der inneren Fläche (200if) des Rückseitenkontakt-Backsheets (200) gebildet wird, die nicht zu etwaigen vorgesehenen Bereichen (250) gehören.

7. Photovoltaikmodul, das umfasst:
ein Rückseitenkontakt-Backsheet nach einem der Ansprüche von 1 bis 6,
wenigstens ein Verbindungselement (700), das einen Kontaktabschnitt (720) und einen Transportabschnitt (740) umfasst, wobei der Kontaktabschnitt (720) an einem Abschnitt der oberen Fläche der Schicht aus elektrisch leitendem Material (22) befestigt ist, der in dem vorgesehenen Bereich (250) eingeschlossen ist, und elektrisch mit der Schicht aus leitendem Material (220) verbunden ist, und der Transportabschnitt (740) wenigstens teilweise in dem Durchgangsloch (256) aufgenommen ist, dass in dem vorgesehenen Bereich (250) liegt.

8. Photovoltaikmodul nach Anspruch 7, wobei das Verbindungselement (700) einen Niet umfasst, der einen Kopf und einen Schaft umfasst, wobei sich der Kopf über eine Ebene erstreckt, die im Wesentlichen parallel zu der Ebene ist, auf der die innere Fläche (200if) des Rückseitenkontakt-Backsheets (200) liegt, der Kontaktabschnitt (720) des Verbindungselementes (700) den Kopf des Niets umfasst und der Transportabschnitt (740) des Verbindungselementes den Schaft des Niets umfasst.

9. Photovoltaikmodul nach einem der Ansprüche 7 oder 8, das des Weiteren ein externes Verbindungselement (900) umfasst, das in elektrischem Kontakt mit dem Verbindungselement (700) ist, wobei das Verbindungselement (700) und das externe Verbindungselement (900) mittels eines Arretierelementes (750) aneinander befestigt sind.

10. Photovoltaikmodul nach einem der Ansprüche 7 bis 9, wobei der Kontaktabschnitt (220) mit einem Befestigungsmittel (770), beispielsweise einem elektrisch leitenden Klebstoff, oder mit einer leitenden Paste, beispielsweise einer Kohlenstoff-Paste oder einer Kupfer-Paste, oder mit einem aus leitendem Metall- oder Elastomermaterial bestehenden Ring, beispielsweise einem Kupferring oder einem Aluminiumring oder einem aus leitendem Elastomer bestehenden Ring, elektrisch mit der Schicht aus leitendem Material (200) verbunden ist.

11. Verfahren zum Herstellen eines Rückseitenkontakt-Backsheets (200) für ein Photovoltaikmodul, das Rückseitenkontakt-Solarzellen umfasst, wobei das Rückseitenkontakt-Backsheet (200) eine äußere Fläche (200of), die der Luft-Seite des Photovoltaikmoduls zugewandt ist, sowie eine innere Fläche (200if) umfasst, die der äußeren Fläche (200of) gegenüberliegt und zur Innenseite des entsprechenden Photovoltaikmoduls hin freiliegt, wobei das Verfahren umfasst:
Bereitstellen eines Substrats (210), das eine äußere Fläche (210os), die mit der äußeren Fläche (200of) des Rückseitenkontakt-Backsheets (200) deckungsgleich ist, sowie eine innere Fläche (210is) hat, die der äußeren Fläche (210os) gegenüberliegt und zu der Innenseite des Photovoltaikmoduls hin freiliegt,
Aufbringen einer Schicht aus einem elektrisch leitenden Material (220), die eine untere Fläche und eine der unteren Fläche gegenüberliegende Oberfläche umfasst, auf das Substrat (210), wobei die Schicht aus elektrisch leitendem Material (220) so auf das Substrat aufgebracht wird, dass die untere Fläche der Schicht aus leitendem Material an der inneren Fläche (210is) des Substrats (210) fixiert wird und dass die innere Fläche (200if) des Rückseitenkontakt-Backsheets die obere Fläche der Schicht aus leitendem Material (22) umfasst,
Bearbeiten der Schicht aus elektrisch leitendem Material (220), um eine Verbindungsschaltung (220c) zur Verbindung mit den Elektroden der Solarzellen auszubilden,
Durchführen einer plastischen Verformung wenigstens eines Bereiches des Rückseitenkontakt-Backsheets (200), der einen Abschnitt der Verbindungsschaltung (220c) enthält, wobei die plastische Verformung so durchgeführt wird, dass ein vorgesehener Bereich (250), der für die Luft-Seite des Photovoltaikmoduls vorgesehen ist, so ausgebildet wird, dass der in dem vorgesehenen Bereich (250) enthaltene Abschnitt der Verbindungsschaltung (220c) einen Hohlraum bildet, der der Innenseite des Photovoltaikmoduls zugewandt ist,
Durchstoßen des Rückseitenkontakt-Backsheets (200) um wenigstens ein Durchgangsloch (256) auszubilden und die obere Fläche der Schicht aus elektrisch leitendem Material (220) in Verbindung mit der äußeren Fläche (200of) des Rückseitenkontakt-Backsheets (200) zu bringen, wobei das Durchgangsloch (256) in dem vorgesehenen Bereich (250) des Rückseitenkontakt-Backsheets (200) enthalten ist.

12. Verfahren nach Anspruch 11, wobei die plastische Verformung nach dem Schritt des Aufbringens der Schicht aus elektrisch leitendem Material (220) auf das Substrat (210) durchgeführt wird.

13. Verfahren nach einem der Ansprüche 11 oder 12, wobei der Schritt des Durchstoßens des Rückseitenkontakt-Backsheets (200) mittels Durchstanzen durchgeführt wird.

14. Verfahren zum Herstellen eines Photovoltaikmoduls, das umfasst:
Herstellen eines Rückseitenkontakt-Backsheets (200) mit dem Verfahren nach einem der Ansprüche von 11 bis 3;
Koppeln wenigstens eines Verbindungselementes (700) mit dem Rückseitenkontakt-Backsheet (200), wobei das Verbindungselement (700) einen Kontaktabschnitt (720) sowie einen Transportabschnitt (740) umfasst und der Koppel-Schritt umfasst:
Einführen wenigstens eines Abschnitts des Transportabschnitts (740) in das Durchgangsloch (256),
Fixieren des Kontaktabschnitts (720) an der Verbindungsschaltung (22), so dass der Kontaktabschnitt (720) elektrisch mit der Verbindungsschaltung (220c) in Kontakt ist.

15. Verfahren nach Anspruch 14, wobei die Verbindungsschaltung (220c) eine obere Fläche (226) umfasst, die in der oberen Fläche der Schicht aus elektrisch leitendem Material
(220) eingeschlossen ist, und der Kontaktabschnitt (720) des Verbindungselementes
(700) an der oberen Fläche (226) der Verbindungsschaltung (220c) fixiert ist.

16. Verfahren nach einem der Ansprüche 14 oder 15, wobei das Verbindungselement (700) einen Niet umfasst, der einen Kopf und einen Schaft umfasst, wobei sich der Kopf über eine Ebene erstreckt, die im Wesentlichen parallel zu der Ebene ist, auf der die innere Fläche (200if) des Rückseitenkontakt-Backsheets (200) liegt, der Kontaktabschnitt (720) des Verbindungselementes (700) den Kopf des Niets umfasst und der Verbindungsabschnitt (740) des Verbindungselementes den Schaft des Niets umfasst.

## Revendications

1. Panneau arrière à contact arrière (200) pour un module photovoltaïque comprenant des cellules solaires a contact arrière, ledit panneau arrière à contact arrière (200) comprenant une face externe (200of) faisant face au côté air d'un module photovoltaïque correspondant et une face interne (200if) opposée à ladite face externe et exposée vers l'intérieur du dit module photovoltaïque correspondant, ledit panneau arrière à contact arrière (200) comprenant :
un substrat (210) possédant une surface externe (210os) sensiblement coïncidente avec ladite face externe (200of) du dit panneau arrière à contact arrière (200) et une surface interne (210is) opposée à ladite surface externe (210os) et exposée vers l'intérieur du dit module photovoltaïque,
une couche d'un matériau électro-conducteur (220) adapté pour être formé comme un circuit de connexion (220c) vers les électrodes des dites cellules solaires, ladite couche de matériau électroconducteur (220) comprenant une surface inférieure faisant face à ladite surface interne (210is) du dit substrat (210) et une surface supérieure opposée à ladite surface inférieure,
un ou plusieurs trous traversant (256) pour mettre en communication ladite surface supérieure de ladite couche conductrice (220) avec ladite face externe (200of) du dit panneau arrière à contact arrière (200),
dans lequel au moins un des dits trous traversant (256) repose dans une région en creux (250) du dit panneau arrière à contact arrière (200) et dans lequel ladite région en creux (250) comprend une partie du dit circuit de connexion (220c) afin que ladite partie du dit circuit de connexion (220c) définie une cavité (251) faisant face à l'intérieur du dit module photovoltaïque.

2. Panneau arrière à contact arrière selon la revendication 1, dans lequel ledit substrat (210) du dit panneau arrière à contact arrière (200) comprend :
une première couche isolante (212) d'un premier matériau polymérique possédant une surface externe faisant face au dit côté air du dit module photovoltaïque et une surface interne opposée à ladite surface externe,
une seconde couche isolante (216) d'un second matériau polymérique couplé à ladite surface interne de ladite première couche isolante (212).

3. Panneau arrière à contact arrière selon l'une des revendication 1 ou 2, dans lequel ledit substrat (210) comprend :
une partie isolante (211) comprenant une surface inférieure faisant face au côté air du dit module photovoltaïque et sensiblement coïncidente avec ladite surface externe (210os) du dit substrat (210) et une surface supérieure opposée à ladite surface inférieure,
une couche primaire (218) fermement fixée à ladite surface supérieure de ladite partie isolante (211), ladite couche primaire (218) comprenant une surface inférieure faisant face à ladite surface supérieure de ladite partie isolante (211) et une surface supérieure opposée à ladite surface inférieure de ladite couche primaire (218) et sensiblement coïncidente avec ladite surface interne (210is) du dit substrat (210).

4. Panneau arrière à contact arrière selon l'une des revendications 1 à 3, dans lequel ladite couche de matériau électro-conducteur (220) comprend du cuivre, de l'aluminium, ou un alliage de cuivre et d'aluminium.

5. Panneau arrière à contact arrière selon l'une des revendications 1 à 4, dans lequel la partie de ladite face interne (200if) du dit panneau arrière à contact arrière (200) inclut dans ladite région en creux (250) est exclusivement constituée d'une partie du dit circuit de connexion (220c).

6. Panneau arrière à contact arrière selon l'une des revendication 1 à 5, dans lequel ladite région en creux (250) comprend une partie sensiblement plate (252) afin que la partie de ladite face interne (200if) du dit panneau arrière à contact arrière (200) inclut dans ladite partie plate (252) repose sur un plan (P2) sensiblement parallèle et placé a une distance prédéterminée (H) par rapport au plan (P1) défini par les parties de ladite face interne (200if) du dit panneau arrière a contact arrière (200) n'appartenant à aucune des régions en creux (250).

7. Un module photovoltaïque comprenant :
un panneau arrière à contact arrière selon l'une des revendications 1 à 6,
au moins un élément de connexion (700) comprenant une partie de contact (720) et une partie de transport (740), ladite partie de contact (720) étant fixée à une partie de ladite surface supérieure de ladite couche de matériau électro-conducteur (220) inclut dans ladite région en creux (250) et
électroniquement connectée avec ladite couche de matériau conducteur (220), ladite partie de transport (740) étant au moins partiellement logée dans le trou traversant (256) qui repose dans ladite région en creux (250).

8. Un module photovoltaïque selon la revendication 7, dans lequel ledit élément de connexion (700) comprend un rivet comprenant une tête et une tige, ladite tête s'étendant à travers un plan sensiblement parallèle au plan sur lequel ladite face interne (200if) du dit panneau arrière à contact arrière (200) repose, ladite partie de contact (720) du dit élément de connexion (700) comprenant ladite tête du dit rivet, ladite partie de transport (740) du dit élément de connexion comprenant ladite tige du dit rivet.

9. Un module photovoltaïque selon l'une des revendication 7 ou 8, comprenant en outre un élément de connexion externe (900) en contact électrique avec ledit élément de connexion (700), dans lequel ledit élément de connexion (700) et ledit élément de connexion externe (900) sont attachés l'un à l'autre par l'intermédiaire d'un élément de verrouillage (750).

10. Un module photovoltaïque selon l'une des revendication 7 à 9, dans lequel ladite partie de contact (220) est connectée électriquement avec ladite couche de matériau conducteur (220) par l'intermédiaire de moyens de fixation (770), par exemple un adhésif électro-conducteur, ou par l'intermédiaire d'une pâte conductrice, par exemple une pâte de carbone ou une pâte de cuivre, ou par l'intermédiaire d'un anneau constitué d'un matériau conducteur métallique ou élastomère, par exemple un anneau de cuivre ou un anneau d'aluminium ou un anneau constitué d'un élastomère conducteur.

11. Procédé de production d'un panneau arrière à contact arrière (200) pour un module photovoltaïque comprenant des cellules solaires à contact arrière, ledit panneau arrière à contact arrière (200) comprenant une face externe (200of) faisant face au côté air du dit module photovoltaïque, et une face interne (200if) opposée à ladite face externe (200of) et exposée vers l'intérieur du dit module photovoltaïque, ladite méthode comprenant :
la fourniture d'un substrat (210) possédant une surface externe (210os) coïncidente avec ladite face externe (200of) du dit panneau arrière à contact arrière (200) et une surface interne (210is) opposée à ladite surface externe (210os) et exposée vers l'intérieur du dit module photovoltaïque,
l'application au dit substrat (210) d'une couche d'un matériau électro-conducteur (210) comprenant une surface inférieure et une surface supérieure opposée à ladite surface inférieure,
ladite couche de matériau électro-conducteur (220) étant appliquée au dit substrat afin que ladite surface inférieure de ladite couche de matériau conducteur (220) est fixée à ladite surface interne (210is) du dit substrat (210) et que ladite face interne (200if) du dit panneau arrière a contact arrière comprend ladite surface supérieure de ladite couche de matériau conducteur (220),
le traitement de ladite couche de matériau électro-conducteur (220) afin de former un circuit de connexion (220c) pour la connexion aux électrodes vers lesdites cellules solaires,
la réalisation d'une déformation plastique d'au moins une région du dit panneau arrière à contact arrière (200) contenant une partie du dit circuit de connexion (220c), ladite déformation plastique étant réalisée afin de former une région en creux (250) qui est en creux vers ledit côté air du dit module photovoltaïque afin que ladite partie du dit circuit de connexion (220c) contenu dans ladite région en creux (250) définisse une cavité faisant face à l'intérieur du dit module photovoltaïque,
le perçage du dit panneau arrière à contact arrière (200) afin de former au moins un trou traversant (256) pour mettre en communication ladite surface supérieure de ladite couche de matériau électro-conducteur (220) avec ladite face externe (200of) du dit panneau arrière à contact arrière (200), ledit trou traversant (256) étant contenu dans ladite région en creux (250) du dit panneau arrière à contact arrière (200).

12. Procédé selon la revendication 11, dans lequel ladite déformation plastique est réalisée après ladite étape d'application de ladite couche de matériau électro-conducteur (220) vers ledit substrat (210).

13. Procédé selon la revendication 11 ou 12, dans lequel ladite étape de perçage du dit panneau arrière à contact arrière (200) est réalisée par l'intermédiaire de perforations.

14. Procédé pour la production d'un module photovoltaïque comprenant :
la production d'un panneau arrière à contact arrière (200) selon le procédé de l'une des revendications 11 à 13 ;
le couplage d'au moins un élément de connexion (700) au dit panneau arrière à contact arrière (200), ledit élément de connexion (700) comprenant une partie de contact (720) et une partie de transport (740), ladite étape de couplage comprenant :
l'insertion d'au moins une partie de ladite partie de transport (740) dans ledit trou traversant (256),
la fixation de ladite partie de contact (720) au dit circuit de connexion (220c) afin que ladite partie de contact (720) contacte électriquement ledit circuit de connexion (220c).

15. Procédé selon la revendication 14, dans lequel ledit circuit de connexion (220c) comprend une surface supérieure (226) inclue dans ladite surface supérieure de ladite couche de matériau électro-conducteur (220) et où ladite partie de contact (720) du dit élément de connexion (700) est fixée à ladite surface supérieure (226) du dit circuit de connexion (220c).

16. Procédé selon l'une des revendication 14 ou 15, dans lequel ledit élément de connexion (700) comprend un rivet comprenant une tête et une tige, ladite tête s'étendant à travers un plan sensiblement parallèle au plan sur lequel ladite face interne (200if) du dit panneau arrière a contact arrière (200) repose, ladite partie de contact (720) du dit élément de connexion (700) comprenant ladite tête du dit rivet, ladite partie de connexion (740) du dit élément de connexion comprenant ladite tige du dit rivet.
